(19) Europäisches Patentamt

European Patent Office

Office européen des brevets

(11) **EP 1 169 778 B1**

(12) **EUROPÄISCHE PATENTSCHRIFT**

(45) Veröffentlichungstag und Bekanntmachung des Hinweises auf die Patenterteilung:
**18.05.2005 Patentblatt 2005/20**

(21) Anmeldenummer: **00916979.8**

(22) Anmeldetag: **20.03.2000**

(51) Int Cl.$^{7}$: **H03M 13/27**

(86) Internationale Anmeldenummer:
**PCT/EP2000/002440**

(87) Internationale Veröffentlichungsnummer:
**WO 2000/057562 (28.09.2000 Gazette 2000/39)**

(54) **DATENÜBERTRAGUNG MIT VERSCHACHTELUNG UND ANSCHLIESSENDER RATENANPASSUNG DURCH PUNKTIERUNG ODER WIEDERHOLUNG**

DATA TRANSMISSION WITH INTERLEAVING AND SUBSEQUENT RATE MATCHING BY PUNCTURING OR REPETITION

TRANSMISSION DE DONNEES AVEC ENTRELACEMENT PUIS ADAPTATION DE DEBITS PAR PERFORATION OU REPETITION

(84) Benannte Vertragsstaaten:
**DE FR GB IT**

(30) Priorität: **19.03.1999 EP 99105680**

(43) Veröffentlichungstag der Anmeldung:
**09.01.2002 Patentblatt 2002/02**

(73) Patentinhaber: **SIEMENS AKTIENGESELLSCHAFT 80333 München (DE)**

(72) Erfinder:
• **RAAF, Bernhard D-81475 München (DE)**
• **SOMMER, Volker D-13503 Berlin (DE)**

(56) Entgegenhaltungen:
**WO-A-00/03486        GB-A- 2 296 165**

**Beschreibung**

Die vorliegende Erfindung betrifft ein Verfahren und eine Vorrichtung zur Datenübertragung mit Verschachtelung und anschließender Ratenanpassung durch Punktierung oder Wiederholung (Repetierung).

Digitale Kommunikationssysteme sind für die Übermittlung von Daten durch Darstellung der Daten in einer Form ausgelegt, die die Übertragung der Daten über ein Kommunikations-Medium erleichtert. Zum Beispiel werden im Fall von Funkübermittlungen die Daten als Funksignale dargestellt zwischen Sendern und Empfängern des Kommunikationssystems übertragen. Im Fall von Breitband-Telekommunikationsnetzen können die Daten als Licht dargestellt werden und zum Beispiel über ein faseroptisches Netz zwischen Sendern und Empfängern des Systems übermittelt werden.

Während der Übertragung von Daten können Bit oder Symbole der übermittelten Daten verfälscht werden, mit dem Effekt, daß diese Bit oder Symbole im Empfänger nicht korrekt bestimmt werden können. Aus diesem Grund enthalten die Datenkommunikationssysteme häufig Mittel zum Mildern der Verfälschung der Daten, die während der Übertragung auftritt. Eines dieser Mittel besteht darin, Sender des Systems mit Codierern auszustatten, die die Daten vor der Übertragung gemäß einem Fehlersteuercode codieren. Der Fehlersteuercode ist so ausgelegt, daß er auf eine gesteuerte Weise den Daten Redundanz hinzufügt. Im Empfänger können Fehler, die während der Übertragung eintreten, korrigiert werden, indem der Fehlersteuercode decodiert wird, wodurch die ursprünglichen Daten wiederhergestellt werden. Die Decodierung wird unter Verwendung eines Fehlerdecodierungsalgorithmus bewirkt, der dem Fehlersteuercode entspricht, der dem Empfänger bekannt ist.

Nachdem die Daten codiert wurden, ist es zur Datenratenanpassung (rate matching) häufig erforderlich, Datenbit oder Symbole aus einem Block codierter Daten zu punktieren oder zu repetieren (Wiederholen), bevor diese Daten übertragen werden. Der Begriff Punktierung soll hier einen Prozeß des Entfernens oder Löschens von Bit aus einem codierten Datenblock bedeuten, mit dem Effekt, daß die punktierten Bit nicht mit diesem Datenblock übertragen werden. Das Punktieren könnte zum Beispiel deshalb erforderlich sein, weil ein Mehrfachzugriffsverfahren, das zur Übermittlung der Daten über die datenführenden Medien dient, eine Formatierung der Daten zu Blöcken mit vorbestimmter Größe erfordert, die nicht der Größe des codierten Datenrahmens entspricht.

Um den codierten Datenrahmen in einem Transport-Datenblock vorbestimmter Größe unterzubringen, werden Datenbit aus dem codierten Datenrahmen deshalb entweder punktiert, um die Größe des codierten Datenblocks zu verkleinern, in einem Fall, bei dem der codierte Datenrahmen größer als die Größe des Transport-Datenblocks ist, oder Bit des codierten Datenrahmens wiederholt, in einem Fall, bei dem der codierte Datenrahmen kleiner als die vorbestimmte Größe des Transport-Datenblocks ist. Im folgenden sei dies beispielhaft anhand eines Mobilfunkkommunikationssystems genauer erläutert:

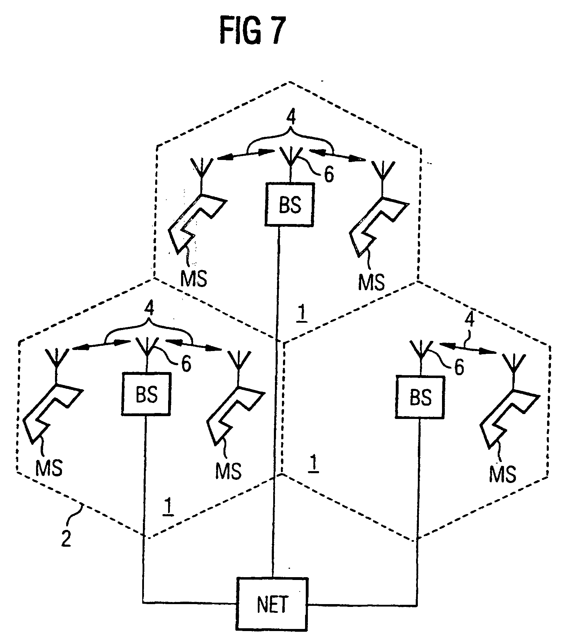

Mobilfunkkommunikationssysteme werden mit Mehrfachzugriffssystemen ausgestattet, die zum Beispiel gemäß dem Mehrfachzugriff im Zeitmultiplex (TDMA) arbeiten, wie zum Beispiel dem in dem Globalen Mobilfunksystem (GSM), einem durch das Europäische Telekommunikationsstandardinstitut standardisierten Mobilfunkkommunikationsstandard, verwendeten. Als Alternative könnte das Mobilfunkkommunikationssystem mit einem Mehrfachzugriffsystem ausgestattet werden, das gemäß dem Mehrfachzugriff im Codemultiplex (CDMA) arbeitet, wie zum Beispiel dem für das universelle Mobiltelekommunikationssystem der dritten Generation vorgeschlagenen UMTS System. Es ist jedoch ersichtlich, daß zur Darstellung einer beispielhaften Ausführungsform der vorliegenden Erfindung ein beliebiges Datenkommunikationssystem verwendet werden könnte, wie zum Beispiel ein lokales Datennetz oder ein Breitband-Telekommunikationsnetz, das gemäß dem asynchronen Übertragungsmodus arbeitet. Diese beispielhaften Datenkommunikationssysteme sind insbesondere dadurch gekennzeichnet, daß Daten als Rahmen, Pakete oder Blöcke übertragen werden. Im Fall eines Mobilfunkkommunikationssystems werden die Daten in Rahmen von datenführenden Funksignalen transportiert, die eine vorbestimmte Datengröße darstellen. Ein Beispiel eines solchen Mobilfunkkommunikationssystems ist in FIG. 7 gezeigt.

In Figur 7 sind drei Basisstationen BS gezeigt, die in einem Funkabdeckungsbereich, der durch Zellen 1, die durch gestrichelte Linien 2 definiert sind, gebildet wird, Funksignale mit Mobilstationen MS austauschen. Die Basisstationen BS sind mit einem Netzrelaysystem NET zusammengekoppelt. Die Mobilstationen MS und die Basisstationen BS tauschen Daten aus, indem sie Funksignale 4 zwischen Antennen 6 übertragen, die an die Mobilstationen MS und an die Basisstationen BS angekoppelt sind. Die Daten werden unter Verwendung einer Datenkommunikationsvorrichtung zwischen den Mobilstationen MS und den Basisstationen BS übermittelt, in der die Daten in die Funksignale 4 transformiert werden, die zu der Empfangsantenne 6 übermittelt werden, die die Funksignale erkennt. Die Daten werden durch den Empfänger aus den Funksignalen wiederhergestellt. Die Erfindung ist dabei sowohl in der Aufwärtsstrecke (MS -> BS) als auch in der Abwärtsstrecke (BS -> MS) einsetzbar.

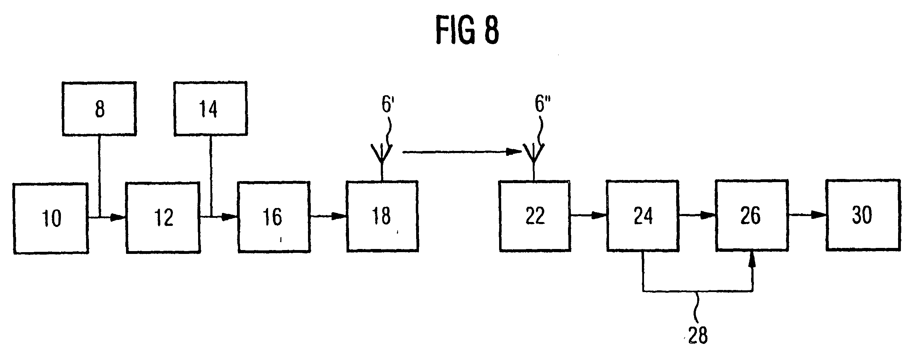

Figur 8 zeigt ein Beispiel einer Datenkommunikationsvorrichtung, die eine Funkkommunikationsstrecke zwischen einer der Mobilstationen MS und einer der Basisstationen BS bildet, wobei Teile, die auch in Figur 7 erscheinen, identische Zahlenbezeichnungen tragen. In Figur 8 erzeugt eine Datenquelle 10 Datenrahmen 8 mit einer Rate, die durch den Datentyp bestimmt wird, den die Quelle erzeugt. Die durch die Quelle 10 erzeugten Datenrahmen 8 werden einem Ratenumsetzer 12 zugeführt, der zum Umsetzen der Datenrahmen 8 zu Transport-Datenblöcken 14 wirkt. Die Transport-Datenblöcke 14 werden so ausgelegt, daß sie im wesentlichen gleich groß sind, mit einer vorbestimmten Größe und einer Datenmenge, die durch Rahmen von datenführenden Funksignalen getragen werden kann, über die Daten durch eine Funkschnittstelle übermittelt werden, die aus einem Paar eines Senders 18 und Empfängers 22 gebildet wird.

Der Transport-Datenblock 14 wird einem Funkzugriffsprozessor 16 zugeführt, der zur Ablaufsteuerung der Übertragung des Transport-Datenblocks 14 über die Funkzugriffsschnittstelle wirkt. Zu einem entsprechenden Zeitpunkt wird der Transport-Datenblock 14 durch den Funkzugriffsprozessor 16 einem Sender 18 zugeführt, der zum Umsetzen des Transport-Datenblocks in den Rahmen von datenführenden Funksignalen wirkt, die in einer Zeitspanne übertragen werden, die für den Sender zugeteilt wird, um die Übermittlung der Funksignale zu bewirken. Im Empfänger 22 erkennt eine Antenne 6" des Empfängers die Funksignale und führt eine Abwärts-Konvertierung und -Wiederherstellung des Datenrahmens durch, der einer Funkzugriffs-Ablaufsteuerungs-umkehrungsvorrichtung 24 zugeführt wird. Die Funkzugriffs-Ablaufsteuerungsumkehrungsvorrichtung 24 führt den empfangenen Transport-Datenblock einer Ratenumsetzungsumkehrungsvorrichtung 26 unter der Steuerung der Mehrfachzugriffs-Ablaufsteuerungs-umkehrungsvorrichtung 24 zu, die über einen Leiter 28 bewirkt wird. Die Ratenumsetzungsumkehrungsvorrichtung 26 führt danach eine Darstellung des wiederhergestellten Datenrahmens 8 einem Ziel bzw. einer Senke für den Datenrahmen 8 zu, das bzw. die durch den Block 30 dargestellt wird.

Der Ratenumsetzer 12 und die Ratenumsetzungsumkehrungsvorrichtung 26 sind so ausgelegt, daß sie soweit wie möglich optimal die in dem Transport-Datenblock 14 verfügbare Datenführungskapazität ausnutzen. Dies wird gemäß einer beispielhaften Ausführungsform der vorliegenden Erfindung durch den Ratenanpassungsumsetzer 12 bewirkt, der zum Codieren des Datenrahmens und anschließenden Punktieren oder Wiederholen von Datenbit oder -symbolen wirkt, die aus dem codierten Datenrahmen ausgewählt werden, mit dem Effekt, daß ein Transport-Datenblock erzeugt wird, der in die Datenblöcke 14 paßt. Der Ratenumsetzer 12 besitzt einen Codierer und einen Punktierer. Der dem Codierer zugeführte Datenrahmen 8 wird codiert, um einen codierten Datenrahmen zu erzeugen, der dem Punktierer zugeführt wird. Der codierte Datenrahmen wird dann durch den Punktierer punktiert, um den Transport-Datenblock 14 zu erzeugen. Je nach Ausführungsvariante ist sowohl in der Aufwärtsstrecke als auch der Abwärtsstrecke das Punktieren von Rahmen einsetzbar.

Aus GB 2296165 A ist ein Multiplex-Kommunikationssystem bekannt, das einen Verschachtelungsschritt und darauffolgend einen Ratenanpassungsschritt durch Wiederhalung oder Punktierung aufweist.

Fachleuten ist bekannt, daß eine Auswirkung des Punktierens eines codierten Datenrahmens darin besteht, daß die Wahrscheinlichkeit für die korrekte Wiederherstellung der ursprünglichen Daten verringert wird. Außerdem ist die Leistung bekannter Fehlersteuercodes und bekannter Decodierer für diese Fehlersteuercodes dann am besten, wenn die Fehler, die während der Übertragung der Daten auftreten, durch Gaußsches Rauschen verursacht werden, da dies den Effekt hat, daß die Fehler unabhängig über den Transport-Datenblock verteilt sind. Wenn ein codierter Datenrahmen punktiert werden soll, sollten die Positionen in dem codierten Datenrahmen, an denen Bit punktiert werden, soweit wie möglich voneinander getrennt werden. Insofern sollten die Punktierungspositionen gleichmäßig über den Datenrahmen verteilt werden. Da Fehler während der Übertragung häufig stoßweise auftreten, insbesondere im Fall von Funkkommunikationssystemen, die keine Verschachtelung einsetzen, und da durch die Wiederholungen von Bit nicht die Qualität nur in einem gewissen Bereich des Datenrahmens besonders erhöht werden soll sondern möglichst gleichmäßig, sollten ähnlich Positionen in einem codierten oder uncodierten Datenrahmen, an denen Datenbit wiederholt werden sollen, so angeordnet werden, daß sie im gesamten Datenrahmen gleichmäßig voneinander getrennt sind.

Zu bekannten Verfahren zum Auswählen der Positionen von Bit oder Symbolen, die in einem codierten Datenrahmen punktiert werden sollen, gehört das Dividieren der Anzahl von Bit oder Symbolen in einem Rahmen durch die Anzahl von Bit oder Symbolen, die punktiert werden sollen, und das Auswählen von Positionen mit ganzzahligen Werten entsprechend der Division. In einem Fall, bei dem die Anzahl von zu punktierenden Bit keine ganzzahlige Division der Anzahl der Bit des Datenrahmens ist, kommt es jedoch nicht zu einer gleichmäßigen Beabstandung der punktierten Positionen, wodurch der Nachteil entsteht, daß der Abstand zwischen bestimmten punktierten Positionen kleiner als diese entsprechende ganze Zahl ist und in manchen Fällen die punktierten Positionen sogar nebeneinander liegen.

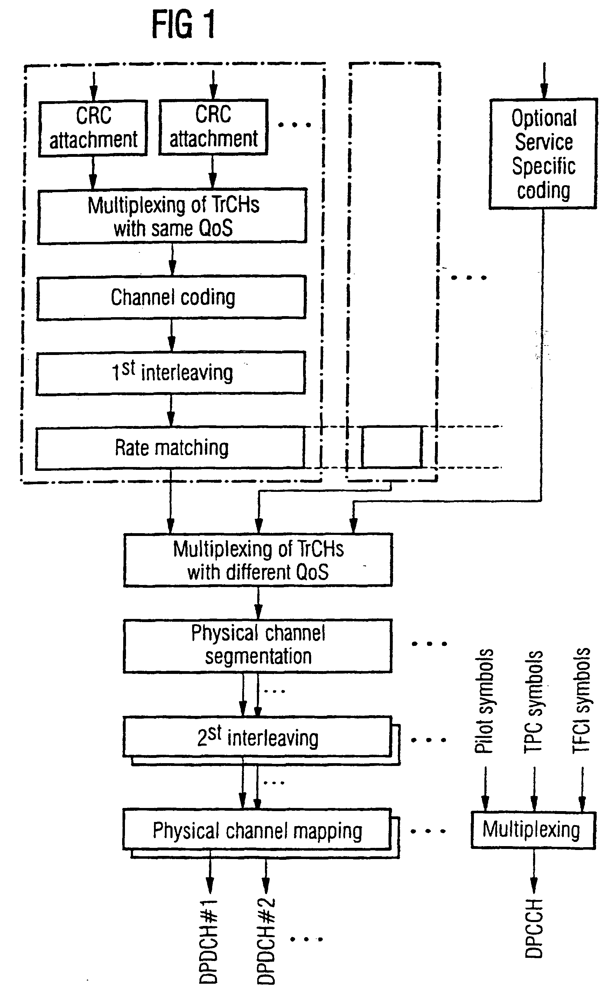

Im folgenden wird zur Beschreibung der komplexen Erfindung das engere technische Umfeld der Erfindung und die dabei auftretenden Probleme anhand der Figuren 1 bis 6 und 9 kurz erläutert, die sich zumindest zum Teil auch aus dem Stand der Standardisierung für die 3. Mobilfunkgeneration (UMTS (Universal Mobile Telecommunications System)) vor der Erfindung ergeben, der insbesondere in folgendem Dokument angegeben ist: S1.12 v0.0.1, 3GPP FDD, Multiplexing, channel coding and interleaving description.

Häufig wird die Verschachtelung im Rahmen eines Transport-Multiplexverfahrens in zwei Schritten durchgeführt. Die verschiedenen Lösungen der Durchführung der Punktierung/Repetierung haben verschiedene Konsequenzen, wenn die Punktierung nach dem ersten Verschachteler (1st interleaver) durchgeführt wird, so wie das für das UMTS-System vorgesehen ist. Zusätzlich wird im UMTS-System noch ein zweiter Interleaver verwendet, welcher nach der Physical channel segmentation und vor dem Physical channel mapping angeordnet wird (siehe Figur 1). Dieser interleaver verbessert zwar die möglichst gleichmäßige Verteilung der gesendeten Bit, hat aber keinen Einfluss auf die Verteilung der punktierten/repetierten Bit und wird daher im Rahmen dieser Erfindung nicht weiter besprochen.

Figur 1 zeigt die Verwendung eines FS-MIL (FS-Multistage Interleaver) als Verschachteler in dem Aufwärtsstrecken-Multiplexverfahren in Verbindung mit einem bekannten für UMTS vorgeschlagenen Ratenanpassungsalgorithmus.

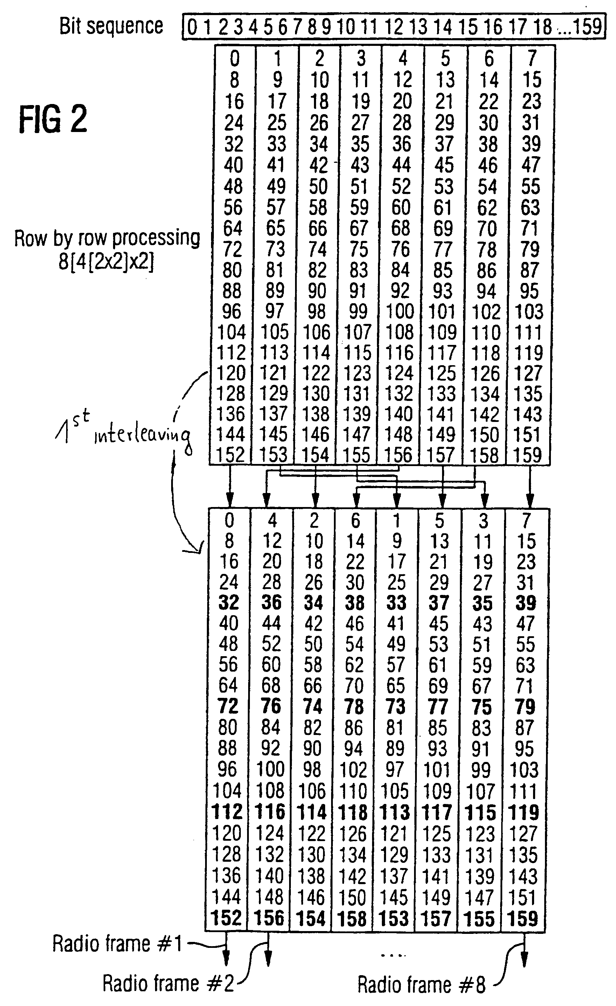

Man betrachte als Beispiel einen Fall, bei dem die Schicht 2 (Layer 2) einen Transportblock mit 160 Bit auf einem Transportkanal mit einem Übertragungsintervall von 80 ms liefert. Diese Bitsequenz kann auch als Datenrahmen oder als Folge von Datenrahmen beschrieben werden. Das bedeutet, daß die Daten nach dem ersten Verschachteler (1st interleaving) über acht Funkrahmen (Radio frame) (im folgenden auch oft als "Rahmen" oder "Spalten" bezeichnet) hinweg verschachtelt sind (siehe Figur 2). Die Verschachtelung besteht hier aus einem zeilenweisen einlesen der Bit und einem spaltenweisen Auslesen der Bit mit nachfolgendem Column randomizing (Spaltenvertauschen).

Ein erstes Ziel eines guten Punktierungsalgorithmus besteht darin, punktierte Bit so gleichmäßig wie möglich über die Bitstellen in ihrer ursprünglichen Reihenfolge zu verteilen. Dies war auch das entscheidende Prinzip welches bei der Definition des Punktierungsalgorithmus für UMTS, wie er z.B. in der o.g. Spezifikation S1.12 beschrieben ist, angewandt wurde. Man erzielt dies am besten durch Punktieren jedes n-ten Bit bzw. bei nicht ganzzahligen Punktierungsraten teilweise jedes (n+ersten) Bit.

Ein zweites Ziel besteht darin, die verschiedenen Rahmen (im folgenden werden Rahmen auch oft als Spalten oder Funkrahmen bezeichnet) gleich oft zu punktieren, und damit auch die punktierten Bit gleichmäßig über alle Rahmen hinweg zu verteilen und auch eine gleichmäßige Punktierung der verschiedenen Rahmen zu erreichen. Unter Punktierung bzw. Wiederholung (Repetierung) einer Spalte (eines Rahmens) versteht man auch die Punktierung bzw. Wiederholung (Repetierung) eines Elements, insbesondere eines Bit der Spalte (des Rahmens).

Man nehme nun an, daß in jedem Rahmen (Funkrahmen) vier Bit punktiert werden sollten, um ein Gleichgewicht der Anforderung an die Qualität des Dienstes dieses Transportkanals mit anderen Kanälen herzustellen. Das Ergebnis des - bisher für das UMTS-System vorgesehenen - Ratenanpassungs-algorithmus besteht darin, daß die Bit 4, 9, 14 und 19 (Index beginnt bei 0, Zählung nach der Reihenfolge der Bit nach dem 1st interleaving) in jedem Rahmen (Funkrahmen) punktiert werden. In Figur 2 ist ein punktiertes Bit fettgedruckt dargestellt. Demzufolge werden acht benachbarte Bit punktiert, was - wie oben erläutert - unerwünscht ist. Das erste obengenannte Ziel wird nicht in zufriedenstellendem Maße erreicht.

Eine Vorgehensweise zur Vermeidung dieses Problems wäre es, das Punktierungsmuster in jedem Rahmen zu verschieben. Es sei $N_i$ die Anzahl von Bit in einem Rahmen vor der Ratenanpassung, $N_c$ die Anzahl von Bit nach der Ratenanpassung, $m_j$ die Positionen der zu punktierenden Bit innerhalb eines verschachtelten Rahmens, k die Rahmennummer und K die Anzahl verschachtelter Rahmen.

Man betrachte den Fall $N_i > N_c$, d.h. Punktieren. In obigem Beispiel ist $N_i = 20$, $N_c = 16$, $m_1 = 4$, $m_2 = 9$, $m_3 = 14$, $m_4 = 19$, k = 1, ..., 7 und K = 8. Ein Verschieben der Positionen der zu punktierenden Bit zur Vermeidung des obengenannten Problems kann dann durch folgende Formel beschrieben werden:

$$m_{j \text{ verschoben}} = (m_j + k \cdot \lceil N_c/(N_i - N_c)/K \rceil) \bmod N_i,$$

wobei $\lceil \ \rceil$ Aufrunden bedeutet.

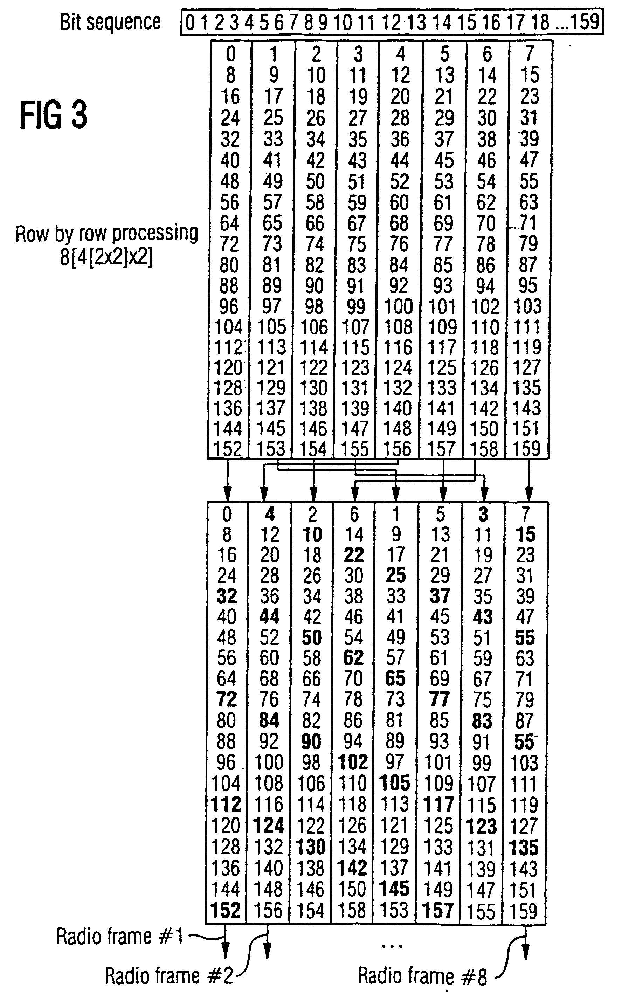

Die sich durch diese Formel ergebenden Positionen der zu punktierenden Bit sind für obiges Beispiel in Figur 3 dargestellt.

Wie aus der Figur 3 ersichtlich ist, wird das Punktieren benachbarter Bit zwar zu einem gewissen Grad vermieden, allerdings entsteht ein Umlauf- oder Randeffekt, d.h. es werden zum Beispiel Bit 43 und Bit 44 punktiert, was - wie oben erläutert - unerwünscht ist. Das erste obengenannte Ziel wird demnach wieder nicht in zufriedenstellendem Maße erreicht.

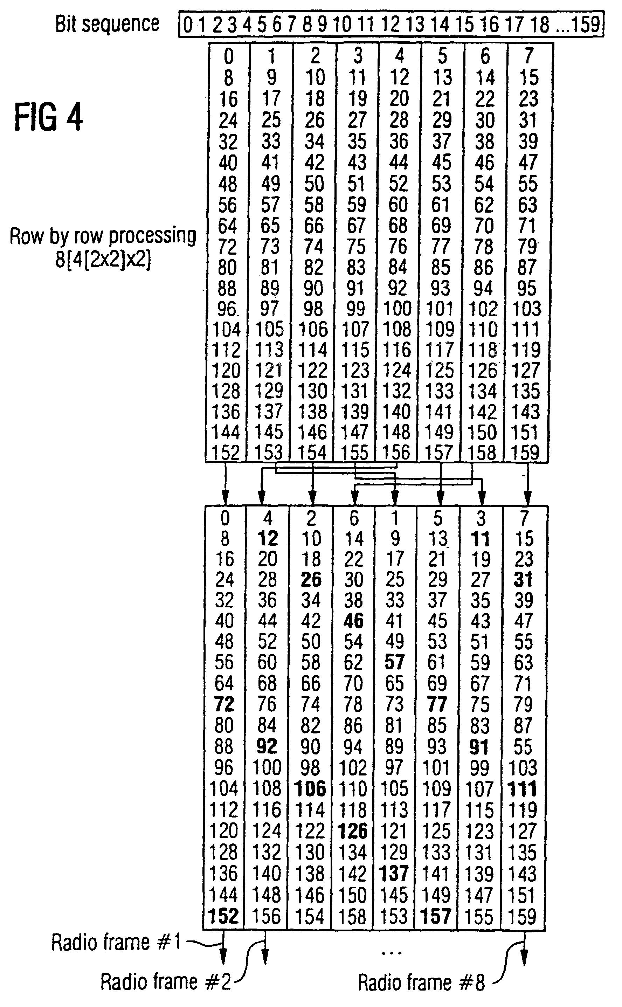

Wenn das Punktierungsverhältnis klein ist, nimmt die Wahrscheinlichkeit des Punktierens benachbarter Bit ab. In Figur 4 ist ein Beispiel mit einem Punktierungsverhältnis von 10% dargestellt. Wie aus Figur 4 ersichtlich ist, werden allerdings immer noch benachbarte Bit (Bit 91 und Bit 92) punktiert, was einen Leistungsverlust zur Folge haben kann. Wieder wird das erste obengenannte Ziel nicht in zufriedenstellendem Maße erreicht.

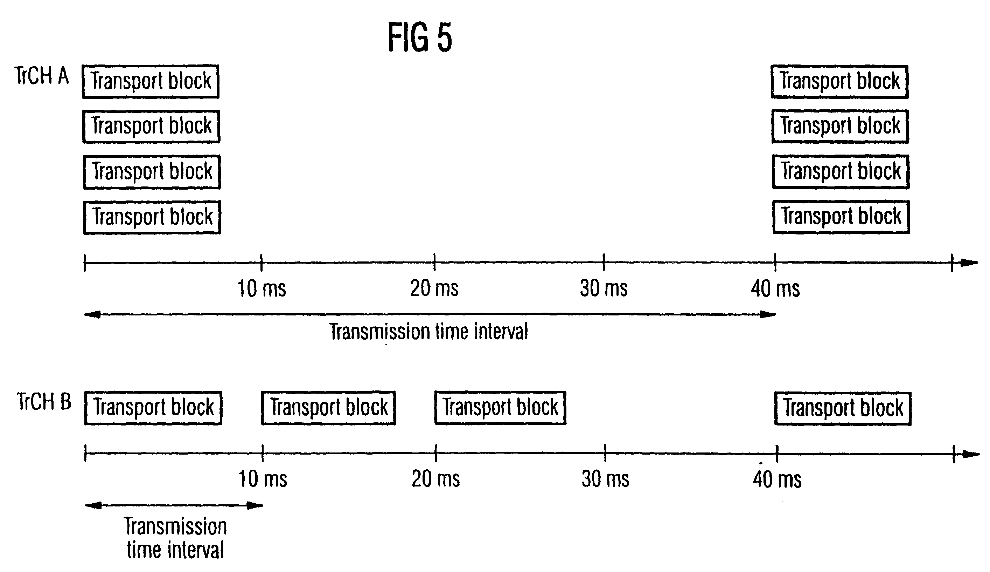

Alternativ zu einem beschriebenen Ratenanpassungsalgorithmus ist vorgeschlagen, den 1. Verschachteler (1st interleaving) dahingehend zu optimieren, daß das Punktieren den beschriebenen Ratenanpassungsalgorithmus nicht mehr erfordert. Ein optimierter 1. Verschachteler sollte die Bit so umordnen, daß benachbarte Bit getrennt werden. Dementsprechend kann das Punktieren leicht durch Entfernen aufeinanderfolgender Bit nach dem Verschachteln durchgeführt werden. Es bestehen jedoch folgende zwei Möglichkeiten, welche anhand des in Figur 5 dargestellten Szenarios näher erläutert werden:

Die vier Transportblöcke auf TrCH A werden zusammen verschachtelt, und danach die Ratenanpassung durchgeführt. Wenn punktiert wird, werden aufeinanderfolgende Bit in jedem Rahmen entfernt. Es ist deshalb sehr unwahrscheinlich, daß punktierte Bit in einem Rahmen hinsichtlich ihrer Position vor dem Verschachteln, also nach dem Codieren benachbart wären. Es besteht jedoch keine Garantie, daß punktierte Bit in verschiedenen Rahmen nach dem Codieren nicht benachbart wären. Demzufolge könnte es bei Verwendung dieses Ansatzes zu einem Leistungsverlust kommen.

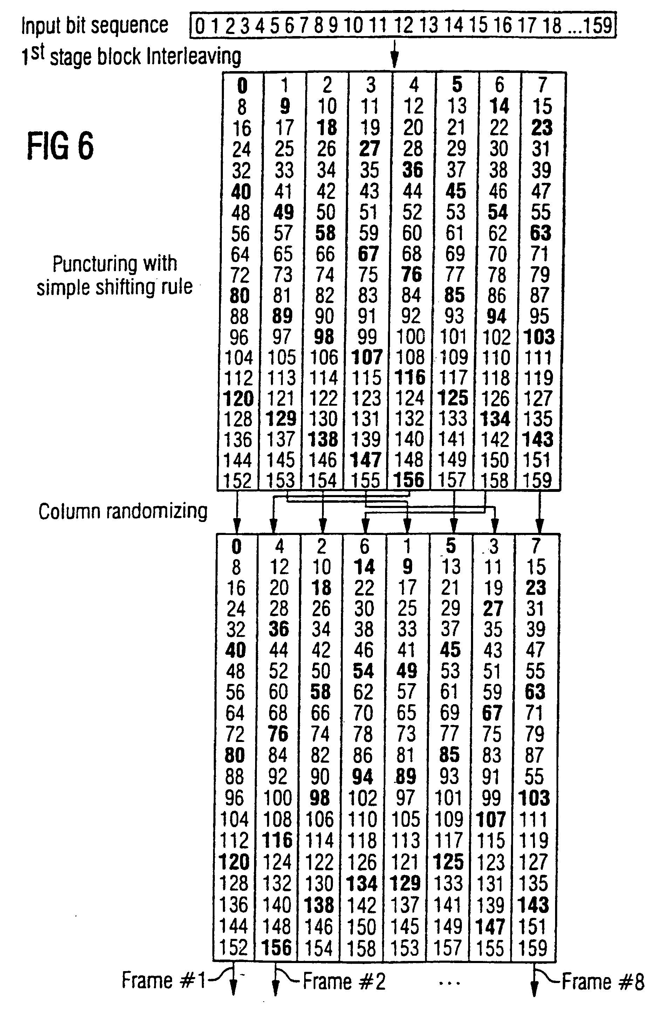

Zur Lösung des anhand Figur 4 erläuterten Problems könnte das folgende anhand Figur 6 erläuterte Verfahren dienen, bei dem das auf einen Rahmen angewandte Punktierungsmuster verschoben auch auf andere Rahmen angewandt wird, wobei die verschobenen Muster auf Rahmen vor der Verschachtelung angewandt werden. In Figur 6 ist ein Punktierungsmuster für das anhand von Figur 3 bereits erläuterte Bitfolgenbeispiel dargestellt. Die Darstellung zeigt, daß das Punktieren benachbarter Bit zumindest in diesem Beispiel nicht auftritt. Deshalb sollte der Leistungsverlust aufgrund des Punktierens in diesem Fall vermieden werden.

Tatsächlich ist es nicht notwendig, die obige Ratenanpassung vor der Spaltenrandomisierung (Spaltenvertauschung) durchzuführen. Eine dazu äquivalente Ratenanpassung kann nach der Spaltenrandomisierung durchgeführt werden, indem die Spaltenrandomisierungsregel berücksichtigt wird, und dies kann leicht nur durch Ersetzen des anfänglichen spaltenspezifischen Offsetwerts $e_{offset}$ , der die Verschiebung der Anwendung des Punktierungsmusters durch eine einfache Formel beschreibt, erzielt werden. Bei der Berechnung des Offsetwerts wird nicht die Spaltennummer nach der Spaltenrandomisierung verwendet, sondern die Spaltennummer vor der Spaltenrandomisierung, die sich unter Verwendung der inversen Spaltenvertauschungsvorschrift berechnen lässt. Darüber hinaus kann e-offset nicht nur beim Punktieren, sondern auch beim Repetieren verwendet werden. Somit können auch Wiederholungsbit gleichförmiger plaziert werden.

Im folgenden wird zusammenfassend noch einmal gezeigt, daß die bisher vorgeschlagenen Lösungen, d.h. die vorgeschlagenen Punktierungs/Repetierungsmuster, noch immer nicht in allen Fällen optimal sind.

Anhand Figur 2 wurde eingangs durch beispielhafte Betrachtung eines Falls, bei dem die Schicht 2 (Layer 2) einen Transportblock mit 160 Bit auf einem Transportkanal mit einem Übertragungsintervall von 80 ms liefert unter der Voraussetzung, daß vier Bit in jedem Rahmen punktiert werden sollten, gezeigt, daß acht benachbarte Bit punktiert werden, was offensichtlich unerwünscht ist. Das erste obengenannte Ziel wird nicht in zufriedenstellendem Maße erreicht.

Der Vorschlag gemäß der Figuren 3 bzw. 4 bestand darin, das Punktierungsmuster in jedem Rahmen zu verschieben. Auch dies führte wie gezeigt zur Punktierung benachbarter Bit (Bit 43 und 44 bzw. Bit 91 und 92). Das erste obengenannte Ziel wird nicht in zufriedenstellendem Maße erreicht.

Der Vorschlag gemäß Figur 6 sieht die Anwendung verschobener Punktierungsmuster nach dem Verschachteln vor, wobei die spaltenspezifischen Verschiebungen anhand von Betrachtungen vor der Spaltenvertauschung ermittelt wurden. Dabei kommt es in diesem Beispiel nicht zu benachbarten punktierten Bit.

Es bestehen jedoch bei einem Verfahren nach Figur 6 immer noch Fälle, bei denen abhängig von der Punktierungsrate benachbarte Bit punktiert werden. Figur 9 zeigt beispielsweise den Fall $N_i=16$, $N_c=14$, $m_1=4$, $m_2=14$, $k=1...$ 7 und K=8. Der Einfachheit halber ist in den Figuren 9 und 10 nur das Feld vor dem Verschachteln gezeigt, in dem allerdings schon die nach dem Verschachteln punktierten Bitstellen durch Fettdruck markiert dargestellt sind. Es ist ersichtlich, daß die benachbarten Bit 31 und 32 und Bit 95-96 punktiert werden, was offensichtlich unerwünscht ist. Wieder ist das erste obengenannte Ziel nicht in zufriedenstellendem Maße erreicht.

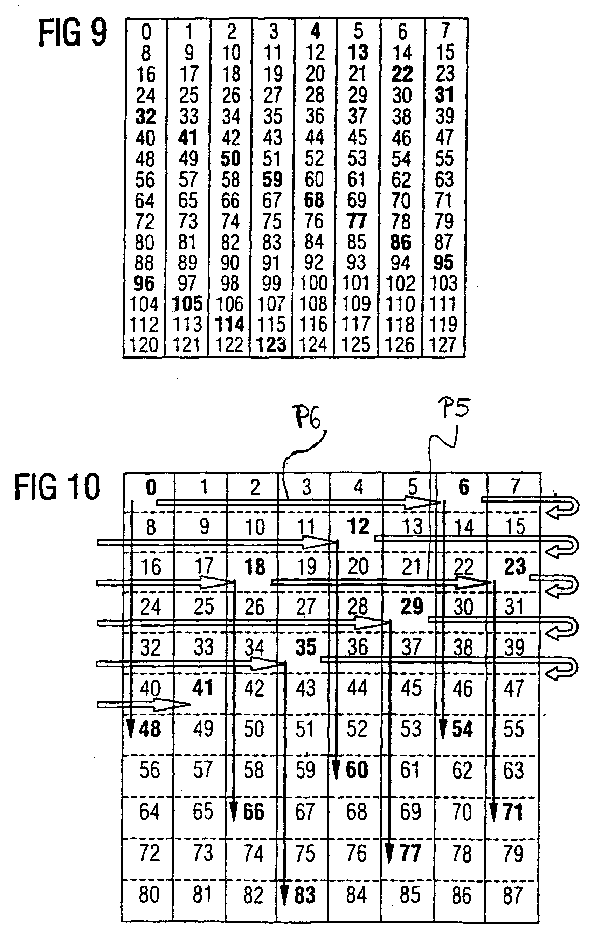

Würde dagegen einfach jedes n-te Bit bezüglich der ursprünglichen Reihenfolge nach dem Verschachteln punktiert werden, so kann das zweite Ziel nicht immer ausreichend erreicht werden. Man nehme zum Beispiel eine 80-ms-Verschachtelung (wie Figur 9) und eine Punktierungsrate von 1:6 an. Durch Punktieren jedes 6. Bit würde nur die Spalten 0,2,4,6, nicht aber die Spalten 1,3,5,7 punktier werden, was natürlich unerwünscht und mit dem zweiten Ziel nicht vereinbar ist. Das erste Ziel würde hingegen in zufriedenstellendem Maße erreicht werden.

Ausgehend davon liegt der Erfindung die Aufgabe zugrunde, diese Nachteile des Standes der Technik zu verringern.

Diese Aufgabe wird gelöst durch die Merkmale der unabhängigen Ansprüche. Weiterbildungen der Erfindung ergeben sich aus den Unteransprüchen.

Ausführungsformen der vorliegenden Erfindung werden nun lediglich als Beispiel mit Bezug auf die beigefügten Zeichnungen beschrieben. Es zeigen:

FIG. 1      vereinfachtes Ablaufdiagramm mit einem Verschachteler vor einer Ratenanpassung (Stand der Technik);

FIG. 2      Verschachtelung und Punktierungsmuster für ein Punktieren von vier Bit pro Rahmen (Stand der Technik);

FIG. 3      Verschachtelung und verschobene Punktierungsmuster für ein Punktieren von vier Bit pro Rahmen (Stand der Technik);

FIG. 4    Verschachtelung und verschobene Punktierungsmuster für ein Punktieren mit einem Punktierungsverhältnis von 10% (Stand der Technik);

FIG. 5    vereinfachte Darstellung von Transportkanälen (Stand der Technik);

FIG. 6    Verschachtelung und verschobene Punktierungsmuster für ein Punktieren von vier Bit pro Rahmen (Stand der Technik);

FIG. 7    ein Blockschaltbild eines Mobilfunkkommunikationssystems (Stand der Technik);

FIG. 8    ein Blockschaltbild einer Datenkommunikationsanordnung, die eine Strecke zwischen der Mobilstation und einer Basisstation des in FIG. 7 gezeigten Kommunikationsnetzes bildet (Stand der Technik);

FIG. 9    Punktierungsmuster für verschobene Punktierungsmuster für ein Punktieren von zwei Bit pro Rahmen (Stand der Technik);

FIG. 10    vereinfachte Darstellung des Prinzips eines hinsichtlich der zwei genannten Ziele optimierten Punktierens;

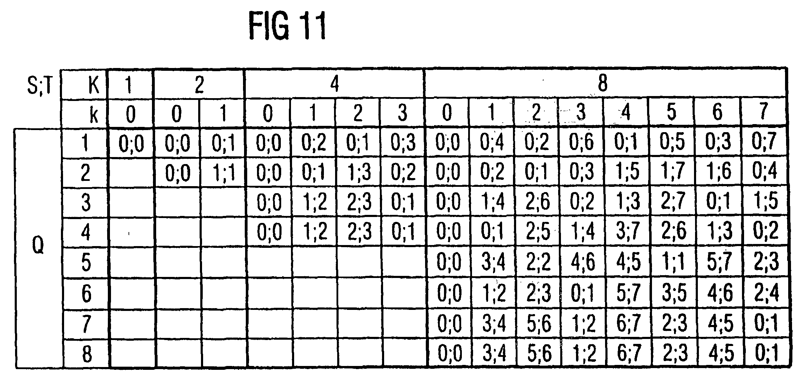

FIG. 11    Nachschlagetabelle;

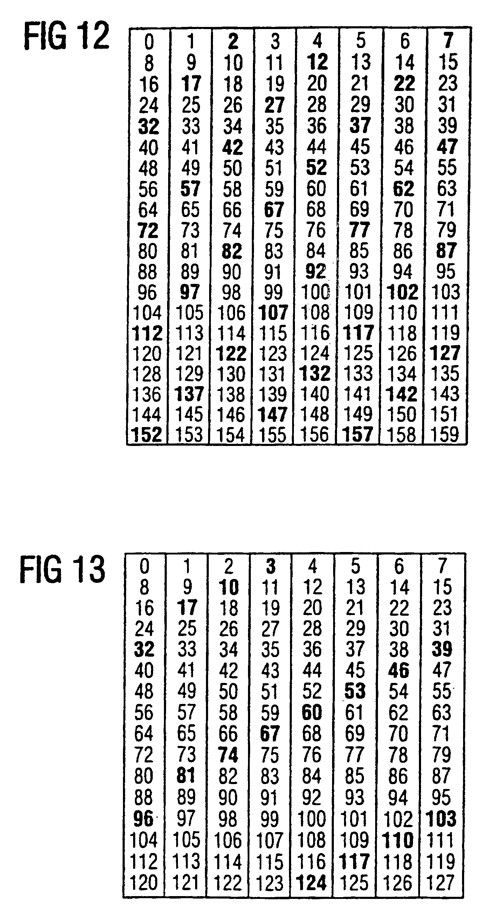

FIG. 12    Punktierungsmuster für ein Punktieren mit einem Punktierungsverhältnis von 20%;

FIG. 13    Punktierungsmuster für ein Punktieren mit einem Punktierungsverhältnis von 1:8;

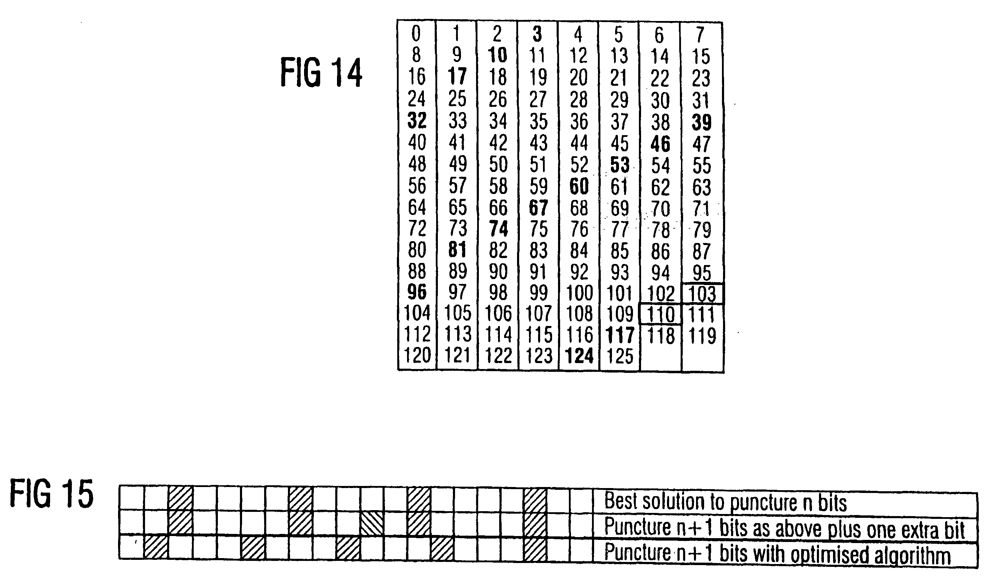

FIG. 14    Punktierungsmuster für ein Punktieren mit ungleicher Anzahl von zu punktierenden Bit pro Rahmen.

Wie oben erläutert kann zwar das zweite Ziel nicht immer ausreichend erreicht werden, wenn nach dem Verschachteln einfach jedes n-te Bit bezüglich der ursprünglichen Reihenfolge vor dem Verschachteln punktiert werden würde. Das erste Ziel würde jedoch in ausreichendem Maße erreicht werden.

Um beide obengenannten Ziele in zufriedenstellendem Maße zu erreichen, sieht nun eine Ausführungsvariante der Erfindung vor, - abweichend von dem bezüglich der ursprünglichen Reihenfolge vor dem Verschachteln gleichmäßigen Punktieren - zumindest einmal, wenn nötig mehrmals, das Punktierungsintervall zu ändern, um zu vermeiden, einzelne Spalten bevorzugt, andere dagegen gar nicht zu punktieren. Dies ist in Figur 10 gezeigt. Horizontale Pfeile (P6) in dünnen Umrißlinien zeigen eine Punktierungsdistanz von 6, und der horizontale Pfeil (P5) in dicken Umrißlinien zeigt eine Punktierungsdistanz 5, um zu vermeiden, die erste Spalte zweimal zu punktieren. Nachdem jede Spalte einmal punktiert wurde, kann das Muster, wie durch die vertikalen Pfeile gezeigt, um 6 Zeilen nach unten verschoben werden, um die nächsten zu punktierenden Bit zu bestimmen. Dies entspricht offensichtlich dem Punktieren jedes 6. Bit in jeder Spalte, also der Anwendung eines Standard-Ratenanpassungrs-Algorithmus, und dem Verschieben von Punktierungsmustern in verschiedenen Spalten gegeneinander.

Im folgenden wird dieses Verfahren nun anhand von Formeln beschrieben:

Es sei $N_i$ die Anzahl von Bit in einem Rahmen vor der Ratenanpassung, $N_c$ die Anzahl von Bit nach der Ratenanpassung, $m_j$ der Index auf die punktierten/wiederholten Bit, k die Spalten- bzw. Rahmennummer nach dem Verschachteln und K die Anzahl Verschachtelter Spalten bzw. Rahmen. Es soll hauptsächlich der Fall $N_i>N_c$ betrachtet werden, d.h. Punktieren; die Formeln sind aber auch für Wiederholung anwendbar.

In dem obigen Beispiel ist $N_i$=20, $N_c$=16, $m_1$=4, $m_2$=9, $m_3$=14, $m_4$=19, k=1...7, wobei k die Spalten- bzw. Rahmennummer nach dem Verschachteln bezeichnet, und K=8. Ein Kommentar ist durch ein vorstehendes "--" gekennzeichnet. Die Verschiebung $V(k) = S(k) + T(k) * Q$ der Anwendung des Punktierungs- oder Wiederholungsmusters auf den Rahmen k kann dann anhand des folgenden Verfahrens ermittelt werden:

--   Berechnen der mittleren Punktierungsdistanz

q:= ($_L$  $N_c$/($|N_i$-$N_c|$)$_⌋$) mod K -- wobei $_L$   $_⌋$ Abrunden und | | Absolutwert bedeutet.

Q:= ($_L$  $N_c$/ ($|N_i$-$N_c|$)$_⌋$) div K

if q gerade -- Sonderfall behandeln:

    then q = q - lcd (q, K) /K -- wobei lcd (q, K) den größten gemeinsamen Teiler von q und K bedeutet

--   man beachte, daß lcd leicht durch Bitmanipulationen berechnet werden kann, weil K eine Zweierpotenz ist.

--   aus demselben Grund können Berechnungen mit q leicht mit binärer Festkommaarithmetik (oder Ganzzahl-Arithmetik und einigen wenigen Schiebeoperationen) durchgeführt werden. endif

-- Berechnen von S und T; S stellt die Verschiebung der Zeile mod K und T den Verschiebebetrag div K dar; S stellt also die Verschiebung der Zeile bezüglich q (also mod K) und T den Verschiebebetrag bezüglich Q (also div K) dar;

for i = 0 to K-1

$$S(R_K (\ulcorner i*q\urcorner \bmod K)) = (\ulcorner i*q\urcorner \operatorname{div} K)$$

-- wobei $\ulcorner\ \urcorner$ Aufrunden bedeutet.

$$T((R_K (\ulcorner i*q\urcorner \bmod K)) = i\ c$$

-- $R_K(k)$ kehrt den Verschachteler um,

end for

Bei einer realen Implementierung können diese Formeln wie in Figur 11 gezeigt als eine Nachschlagetabelle implementiert werden. Die Tabelle enthält außerdem den bereits beschriebenen Effekt der durch $R_K(k)$ erzielten Um-Abbildung der Spaltenrandomisierung. S kann offensichtlich als eine weitere Implementierungsoption auch aus T berechnet werden.

Danach kann $e_{offset}$ folgendermaßen berechnet werden:

$$e_{offset} (k) = ((2*S) + 2*T\ Q +1)*\ y + 1) \bmod 2Nc$$

Mit $e_{offset}$ (k) wird dann e im Ratenanpassungsverfahren für UMTS vorgeladen. Diese Wahl von $e_{offset}$ bewirkt offensichtlich eine Verschiebung der Punktierungsmuster der Spalten relativ zueinander um den Betrag S + T * Q.

Eine vereinfachte Darstellung ist im folgenden beschrieben, welche sich einfach daraus ergibt, daß die Berechnung von q und Q nicht getrennt für den Rest bei der Teilung durch K und das Vielfache von K durchgeführt wird, sondern kombiniert für beide Anteile. Des gleichen können S und T nicht getrennt für q und Q berechnet werden, sondern ebenfalls kombiniert. Die Substitution q+K*Q --> q und S+Q*T --> S ergibt die folgende äquivalente Darstellung des oben angegebenen Verfahrens, wobei für die Verschiebung V(k) in diesem Fall gilt: V(k) = S(k). Je nach den Details der Implementierung kann die eine oder andere Berechnungsmethode (oder weitere dazu ebenfalls äquivalente Methoden) günstiger durchgeführt werden.

-- Berechnen der mittleren Punktierungsdistanz

q:= $(\llcorner N_c/(|N_i-N_c|)\lrcorner)$ -- wobei $\llcorner\ \lrcorner$ Abrunden und | | Absolutwert bedeutet.

if q gerade -- Sonderfall behandeln:

then q = q - lcd(q, K)/K -- wobei lcd(q, K) den größten gemeinsamen Teiler von q und K bedeutet

-- man beachte, daß lcd leicht durch Bitmanipulationen berechnet werden kann, weil K eine Zweierpotenz ist.

-- aus demselben Grund können Berechnungen mit q leicht mit binärer Festkommaarithmetik (oder Ganzzahl-Arithmetik und einigen wenigen Schiebeoperationen) durchgeführt werden. endif

-- Berechnen von S(k), der Verschiebung der Spalte k ;

for i = 0 to K-1

$$S(R_K (\ulcorner i*q\urcorner \bmod K)) = (\ulcorner i*q\urcorner \operatorname{div} K)$$

-- wobei $\ulcorner\ \urcorner$ Aufrunden bedeutet.

-- $R_K(k)$ kehrt den Verschachteler um

end for

Danach kann $e_{offset}$ folgendermaßen berechnet werden:

$$e_{offset} (k) = ((2*S)*\ y + 1) \bmod 2Nc$$

Mit $e_{offset}$ (k) wird dann e im voraus in dem Ratenanpassungsverfahren initialisiert.

Falls die Punktierungsrate ein ungeradzahliger Bruchteil, d.h. 1:5 oder 1:9 ist, wird durch dieses Verfahren ebenfalls ein hinsichtlich der beiden obengenannten Ziele optimale Punktierungmuster erzeugt, das durch das Punktieren unter Verwendung des Ratenanpassungsverfahrens direkt vor dem Verschachteln angewandt würde. In anderen Fällen werden niemals benachbarte Bit punktiert, eine Distanz zwischen benachbarten punktierten Bit kann aber um bis zu lcd(q,K)+1 größer als die anderen sein. Dieses Verfahren kann entsprechend auch auf Bitwiederholungen (Bitrepetierungen) angewandt werden. Obwohl das Wiederholen benachbarter Bit die Leistungsfähigkeit der Fehlerkorrekturcodes nicht so stark beeinträchtigt, wie das beim Punktieren benachbarter Bit der Fall ist, ist es dennoch vorteilhaft, wiederholte Bit so gleichmäßig wie möglich zu verteilen.

Die grundsätzliche Zielsetzung dieses Verfahrens besteht darin, einen gleichmäßigen Abstand zwischen den punktierten Bit in der ursprünglichen Reihenfolge zu erzielen, wobei aber die Einschränkung berücksichtigt wird, daß in den verschiedenen Rahmen die gleiche Anzahl von Bit zu punktieren ist. Dies wird dadurch erreicht, daß die Punktierungsdistanz in bestimmten Fällen um 1 verringert wird. Das vorgestellte Verfahren ist insofern optimal, als es die Distanz niemals um mehr als 1 verringert und sie nur so oft wie notwendig verringert. Dies ergibt das bestmögliche Punktierungsmuster unter den oben erwähnten Einschränkungen.

Das folgende Beispiel zeigt anhand Figur 12 das Punktieren mit einem Punktierungsverhältnis von 1:5. Der optimierte Algorithmus vermeidet offensichtlich nicht nur das Punktieren benachbarter Bit, sondern verteilt punktierte Bit außerdem mit gleichem Abstand hinsichtlich der ursprünglichen Reihenfolge. Tatsächlich werden dieselben Eigenschaften erzielt, als ob das Punktieren direkt nach dem Codieren vor dem Verschachteln durchgeführt worden wäre. In diesem Spezialfall der Punktierung von 1:5 und allgemeiner gesagt immer dann, wenn sich die Punktierungsrate als Bruch 1:q schreiben lässt, wobei q ganzzahlig ist und q und K, die Anzahl der Rahmen, teilerfremd sind, gilt, daß trotz Anwendung der Punktierung nach dem ersten Verschachtler ein optimales Punktierungsmuster erzeugt wird. Dieses Punktierungsmuster bewirkt die Punktierung jedes q-ten Bit, so wie ein optimales Punktierungsmuster, das unmittelbar nach dem Codieren vor dem Verschachteln durchgeführt worden wäre.

Es soll nun anhand Figur 13 das Punktieren mit einem Punktierungsverhältnis von 1:8 betrachtet werden. Wieder wird das Punktieren benachbarter Bit vermieden. In diesem Fall ist es nicht möglich, eine gleichmäßig beabstandete Punktierung zu erzielen, weil dann alle Bit eines einzelnen Rahmens punktiert würden, was mit Blick auf das zweite Ziel völlig unannehmbar ist. In diesem Fall betragen die meisten der Distanzen zwischen benachbarten Bit 7 (nur 1 weniger als bei einer optimalen Verteilung). Dafür sind manche Distanzen größer (jede achte).

Wenn die Anzahl $N_i$ von Eingangsbit nicht durch K teilbar ist, kann sich die Ratenanpassung während des Übertragungszeitintervalls ändern. Die letzten Rahmen führen dann ein Bit weniger als die ersten und weisen deshalb auch eine etwas kleinere Punktierungsrate auf. Für diesen Fall sieht eine Ausführungsvariante der Erfindung vor, das Punktierungsmuster in den letzten Zeilen nicht zu verändern. Statt dessen wird derselbe Punktierungsalgorithmus wie für die ersten Spalten verwendet, jedoch ohne die letzte Punktierung durchzuführen. Man betrachte anhand Figur 14 als Beispiel, daß 125 Eingangsbit derart punktiert werden sollen, daß 104 Ausgangsbit übrig bleiben, die über acht Rahmen hinweg verschachtelt werden. Die letzten beiden Spalten weisen ein Eingangsbit weniger als die ersten auf; durch Auslassen der letzten Punktierung in den beiden letzten Spalten weisen alle Spalten 13 Bit auf.

Durch das hier vorgeschlagene Verfahren lassen sich hinsichtlich der oben genannten Ziele optimierte Punktierungsmuster angeben, wenn die Ratenanpassung nach der ersten Verschachtelung angewandt wird. Das Verfahren ist einfach, erfordert wenig Rechenleistung und muß nur einmal pro Rahmen und nicht einmal pro Bit ausgeführt werden. Das Verfahren ist nicht auf Funkübertragungssysteme beschränkt.

**Patentansprüche**

1. Verfahren zur Datenratenanpassung,
   bei dem zu übertragende Bit durch einen ersten Verschachtler auf einen Satz von K Rahmen verteilt werden,
   bei dem zur Datenratenanpassung nach dem Verschachteln ein Punktierungs- oder Wiederholungsverfahren derart durchgeführt wird, dass
   zur Punktierung oder Wiederholung der gleichen Anzahl von Bit in jedem Rahmen der Abstand zwischen punktierten oder wiederholten Bit hinsichtlich der Reihenfolge der Bit vor dem ersten Verschachtler variiert wird,
   wobei zu punktierende oder zu wiederholende Bit durch ein Verfahren erhältlich sind, das folgende Schritte enthält:

   a) Bestimmung des ganzzahligen Anteils q der mittleren Punktierungsdistanz mit

$$q := ( \lfloor N_c/(|N_i - N_c|) \rfloor ) ,$$

wobei L J Abrunden und | | Absolutwert bedeutet,
und wobei gilt:

$N_i$ := die Anzahl der Bit nach der Ratenanpassung,
$N_c$ := die Anzahl der Bit vor der Ratenanpassung;

b) Auswahl eines zu punktierenden oder zu wiederholenden Bit in einem ersten Rahmen;

c) Auswahl des nächsten zu punktierenden oder zu wiederholenden Bit in einem nächsten Rahmen ausgehend von dem zuletzt zu punktierenden oder zu wiederholenden Bit im vorigen Rahmen dadurch, dass beginnend mit diesem zuletzt zu punktierenden oder zu wiederholenden Bit jeweils das nächste Bit mit Abstand q, bezogen auf die ursprüngliche Reihenfolge vor dem Verschachtler, ausgewählt wird, sofern dies nicht dazu führt, dass ein Rahmen doppelt punktiert oder wiederholt wird, ansonsten zur Punktierung oder Wiederholung ein Bit mit gegenüber q verändertem Abstand q-1 oder q+1 ausgewählt wird;

d) Wiederholung des Schritts c) bis alle Rahmen einmal punktiert bzw. wiederholt wurden.

2. Verfahren nach Anspruch 1, bei dem
Bit eines ersten Rahmens gemäß einem vorgegebenen Punktierungsmuster oder Wiederholungsmuster punktiert oder wiederholt werden, und
zur Auswahl weiterer zu punktierender oder zu wiederholender Bit das Punktierungsmuster oder Wiederholungsmuster verschoben auf weitere Rahmen angewendet wird, wobei die Verschiebung der Anwendung des Punktierungsmusters oder Wiederholungsmusters auf einen weiteren Rahmen der Verschiebung des in Schritt c) des Anspruch 1 gewählten Bit des weiteren Rahmens gegenüber dem in Schritt b) des Anspruch 1 gewählten Bit entspricht.

3. Verfahren zur Datenratenanpassung nach einem der Ansprüche 1 oder 2,
bei dem für den Abstand folgende Beziehung gilt:
q-1 ≤ Abstand ≤ q + lcd(q,K) +1, wobei gilt:
q:= (L $N_c$/(|$N_i$-$N_c$|)J) mod K , wobei L ⌋ Abrunden und | | Absolutwert bedeutet und wobei $N_i$ := die Anzahl der Bit nach der Ratenanpassung, $N_c$ := die Anzahl der Bit vor der Ratenanpassung;
lcd(q, K) := größter gemeinsamer Teiler von q und K.

4. Verfahren nach Anspruch 3,
bei dem folgende Beziehung auch dann gilt, wenn die Punktierungsrate oder die Wiederholungsrate gleich 1/K ist:
q-1 ≤ Abstand ≤ q + lcd(q,K) +1, wobei gilt:
q:= (L $N_c$/(|$N_i$-$N_c$|)J) mod K , wobei L ⌋ Abrunden und | | Absolutwert bedeutet und wobei $N_i$ := die Anzahl der Bit nach der Ratenanpassung, $N_c$ := die Anzahl der Bit vor der Ratenanpassung;
lcd(q, K) := größter gemeinsamer Teiler von q und K.

5. Verfahren zur Datenratenanpassung,
bei dem zu übertragende Bit durch einen ersten Verschachtler auf einen Satz von K Rahmen verteilt werden,
bei dem zur Datenratenanpassung nach dem Verschachtelnwein Punktierungs- oder Wiederholungsverfahren derart durchgeführt wird, dass
in jedem Rahmen die gleiche Anzahl von Bits punktiert bzw. wiederholt wird, dass
das innerhalb eines Rahmens angewendete Punktierungs- oder Wiederholungsmuster verschoben auch innerhalb weiterer Rahmen des Satzes von Rahmen angewendet wird,
dass für jede Position des Punktierungs- oder Wiederholungsmusters die Menge der K Bits in den K Rahmen, die alle dieser Position (ggf. verschoben) entsprechen, so bestimmt wird, dass die Abstände zwischen diesen K Bits, bezogen auf die ursprüngliche Reihenfolge vor dem Verschachtler, gemäß einem mittleren ganzzahligen Punktierungsabstand bzw. Repetierungsabstand gewählt werden, außer in dem Fall, dass die Wahl dieses Abstands dazu führen würde, dass ein Rahmen doppelt punktiert oder wiederholt würde, und in diesem Fall ein um eins veränderter Abstand gewählt wird.

6. Verfahren nach Anspruch 5,
bei dem die Verschiebung V(k) = S(k) + T(k) * Q der Anwendung des Punktierungs- oder Wiederholungsmusters auf den Rahmen k durch folgende Schritte erhältlich ist:

- Berechnen der mittleren Punktierungsdistanz q, wobei gilt:

$$q := (\lfloor N_c/(|N_i - N_c|)\rfloor) \bmod K \text{ , wobei } \lfloor \quad \rfloor \text{ Abrunden und } |\,| \text{ Absolutwert bedeutet,}$$

und wobei gilt:

$N_i :=$ die Anzahl der Bit nach der Ratenanpassung,
$N_c :=$ die Anzahl der Bit vor der Ratenanpassung;

- Berechnen von Q, wobei gilt: $Q := (\lfloor N_c/(|N_i - N_c|)\rfloor) \text{ div } K$;
- wenn q gerade ist, dann wird q zu q - lcd(q, K)/K gesetzt, wobei gilt lcd(q, K):= der größte gemeinsame Teiler von q und K;
- Nullsetzen einer Variablen i;
- Wiederholen der folgenden Schritte solange $i \leq K-1$:

  - $S(R_K(\lceil i*q\rceil \bmod K)) = (\lceil i*q\rceil \text{ div } K)$ , wobei $\lceil \ \rceil$ Aufrunden bedeutet und $R_K(k)$ den Verschachteler umkehrt;
  - $T((R_K(\lceil i*q\rceil \bmod K)) = i$, wobei $\lceil \ \rceil$ Aufrunden bedeutet und $R_K(k)$ den Verschachteler umkehrt;
  - i wird zu i + 1.

**7.** Verfahren nach Anspruch 5,
bei dem die Verschiebung V(k) = S(k) der Anwendung des Punktierungs- bzw. Wiederholungsmusters auf den Rahmen k durch folgende Schritte erhältlich ist:

- Berechnen der mittleren Punktierungsdistanz q, wobei gilt:

$$q := (\lfloor N_c/(|Ni - N_c|)\rfloor) \text{ , wobei } L \rfloor \text{ Abrunden und } |\,| \text{ Absolutwert bedeutet,}$$

und wobei gilt:

$N_i :=$ die Anzahl der Bit nach der Ratenanpassung,
$N_c :=$ die Anzahl der Bit vor der Ratenanpassung;

- wenn q gerade ist, dann wird q zu q - lcd(q, K)/K gesetzt, wobei gilt lcd(q, K):= der größte gemeinsame Teiler von q und K; - Nullsetzen einer Variablen i;
- Wiederholen der folgenden Schritte solange $i \leq K-1$:

  - $S(R_K(\lceil i*q\rceil \bmod K)) = (\lceil i*q\rceil \text{ div } K)$ , wobei $\lceil \ \rceil$ Aufrunden bedeutet und $R_K(k)$ den Verschachteler umkehrt;
  - $R_K(k)$ , wobei $R_K(k)$ den Verschachteler umkehrt;
  - i wird zu i + 1.

**8.** Datenratenanpassungsvorrichtung für durch einen ersten Verschachtler auf einen Satz von K Rahmen verteilte zu übertragende Bit,
mit einem Ratenumsetzer, der derart eingerichtet ist, dass nach dem Verschachteln ein Punktierungs- oder Wiederholungsverfahren derart durchgeführt wird, dass
zur Punktierung oder Wiederholung der gleichen Anzahl von Bit in jedem Rahmen der Abstand zwischen punktierten oder wiederholten Bit hinsichtlich der Reihenfolge der Bit vor dem ersten Verschachtler variiert wird,
wobei zu punktierende oder zu wiederholende Bit durch ein Verfahren erhältlich sind, das folgende Schritte enthält:

a) Bestimmung des ganzzahligen Anteils q der mittleren Punktierungsdistanz mit

$$q := (\lfloor N_c/(|N_i - N_c|)\rfloor) \text{ ,}$$

wobei L J Abrunden und $|\,|$ Absolutwert bedeutet,
und wobei gilt:

$N_i$ := die Anzahl der Bit nach der Ratenanpassung,
$N_c$ := die Anzahl der Bit vor der Ratenanpassung;

b) Auswahl eines zu punktierenden oder zu wiederholenden Bit in einem ersten Rahmen;

c) Auswahl des nächsten zu punktierenden oder zu wiederholenden Bit in einem nächsten Rahmen ausgehend von dem zuletzt zu punktierenden oder zu wiederholenden Bit im vorigen Rahmen dadurch, dass beginnend mit diesem zuletzt zu punktierenden oder zu wiederholenden Bit jeweils das nächste Bit mit Abstand q, bezogen auf die ursprüngliche Reihenfolge vor dem Verschachtler, ausgewählt wird, sofern dies nicht dazu führt, dass ein Rahmen doppelt punktiert oder wiederholt wird, ansonsten zur Punktierung oder Wiederholung ein Bit mit gegenüber q verändertem Abstand q-1 oder q+1 ausgewählt wird;

d) Wiederholung des Schritts c) bis alle Rahmen einmal punktiert bzw. wiederholt wurden.

**9.** Datenratenanpassungsvorrichtung nach Anspruch 8,
mit einem Ratenumsetzer, der derart eingerichtet ist,
dass Bit eines ersten Rahmens gemäß einem vorgegebenen Punktierungsmuster oder Wiederholungsmuster punktiert, oder wiederholt werden, und
dass zur Auswahl weiterer zu punktierender oder zu wiederholender Bit das Punktierungsmuster oder Wiederholungsmuster verschoben auf weitere Rahmen angewendet wird, wobei die Verschiebung der Anwendung des Punktierungsmusters oder Wiederholungsmusters auf einen weiteren Rahmen der Verschiebung des in Schritt c) des Anspruch 1 gewählten Bit des weiteren Rahmens gegenüber dem in Schritt b) des Anspruch 1 gewählten Bit entspricht.

**10.** Datenratenanpassungsvorrichtung für durch einen ersten Verschachtler auf einen Satz von K Rahmen verteilte zu übertragende Daten in Form von Bit,
mit einem Ratenumsetzer, der derart eingerichtet ist, dass zur Datenratenanpassung nach dem Verschachteln ein Punktierungs- oder Wiederholungsverfahren derart durchgeführt wird, dass
in jedem Rahmen die gleiche Anzahl von Bits punktiert bzw. wiederholt wird, dass
das innerhalb eines Rahmens angewendete Punktierungs- oder Wiederholungsmuster verschoben auch innerhalb weiterer Rahmen des Satzes von Rahmen angewendet wird,
dass für jede Position des Punktierungs- oder Wiederholungsmusters die Menge der K Bits in den K Rahmen, die alle dieser Position (ggf. verschoben) entsprechen, so bestimmt wird, dass die Abstände zwischen diesen K Bits, bezogen auf die ursprüngliche Reihenfolge vor dem Verschachtler, gemäß einem mittleren ganzzahligen Punktierungsabstand bzw. Repetierungsabstand gewählt werden, außer in dem Fall, dass die Wahl dieses Abstands dazu führen würde, dass ein Rahmen doppelt punktiert oder wiederholt würde, und in diesem Fall ein um eins veränderter Abstand gewählt wird.

## Claims

**1.** Method for data rate matching,
in which the bits to be transmitted are distributed by means of a first interleaver over a set of K frames,
in which a puncturing or repetition method is carried out for data rate matching after the interleaving process, in such a way that,
in order to puncture or repeat the same number of bits in each frame, the distance between punctured or repeated bits is varied with respect to the sequence of the bits before the first interleaver,
with bits to be punctured or to be repeated being obtainable by means of a method which includes the following steps:

a) determination of the integer component q of the mean puncturing distance where:

$$q := (\lfloor N_c/(|N_i-N_c|) \rfloor),$$

where $\lfloor \rfloor$ means rounding down and $|\,|$ means an absolute value,
and where:

$N_i$: = the number of bits after rate matching, and

$N_c$: = the number of bits before rate matching;

b) selection of a bit to be punctured or to be repeated in a first frame;

c) selection of the next bit to be punctured or to be repeated in a next frame on the basis of the most recent bit to be punctured or to be repeated in the previous frame, in that, starting with this most recent bit to be punctured or to be repeated, the next bit is in each case selected at a distance q, with respect to the original sequence before the interleaver, provided that this does not lead to a frame being punctured or repeated twice, otherwise a bit at a distance q-1 or q+1, which is not the same as q, is selected for puncturing or repetition;

d) repetition of step c) until all of the frames have been punctured or repeated once.

2. Method according to Claim 1, in which
bits in a first frame are punctured or repeated in accordance with a predetermined puncturing pattern or repetition pattern, and
the puncturing pattern or repetition pattern is applied shifted to further frames for selection of further bits to be punctured or to be repeated, with the shift in the application of the puncturing pattern or repetition pattern to a further frame corresponding to the shift of the bit selected in step c) of Claim 1 in the further frame with respect to the bit selected in step b) in Claim 1.

3. Method for data rate matching according to one of Claims 1 or 2,
in which the following relationship applies to the distance:

$$q\text{-}1 \leq distance \leq q + lcd\ (q,K) + 1,$$

where:
q:= $(\lfloor N_c/(|N_i\text{-}N_c|)\rfloor)$ mod K, where $\lfloor\ \rfloor$ means rounding down and $|\ |$ means an absolute value, and where $N_i$: = the number of bits after rate matching, and $N_c$: = the number of bits before rate matching,
lcd(q, K): = largest common denominator of q and K.

4. Method according to Claim 3,
in which the following relationship also applies when the puncturing rate or the repetition rate is equal to 1/K:

$$q\text{-}1 \leq distance \leq q + lcd\ (q,K) + 1,$$

where:
q:= $(\lfloor N_c/(|N_i\text{-}N_c|)\rfloor)$ mod K, where $\lfloor\ \rfloor$ means rounding down and $|\ |$ means an absolute value, and where: $N_i$: = the number of bits after rate matching, and $N_c$: = the number of bits before rate matching,
lcd(q, K): = largest common denominator of q and K.

5. Method for data rate matching,
in which the bits to be transmitted are distributed by means of a first interleaver over a set of K frames,
in which a puncturing or repetition method is carried out for data rate matching after the interleaving process, in such a way that
the same number of bits are punctured or repeated in each frame, in that
the puncturing or repetition pattern which is used within one frame is also applied shifted within further frames in the set of frames,
in that the set of K bits in the K frames which all correspond to this position (possibly shifted) is determined for each position in the puncturing or repetition pattern such that the distances between these K bits, with respect to the original sequence before the interleaver, is selected in accordance with a mean integer puncturing distance or repetition distance, except in the situation where the selection of this distance would lead to one frame being punctured or repeated twice, and in this situation a distance changed by one is selected.

6. Method according to Claim 5,
in which the shift (V(k) = S(k) + T(k) * Q in the application of the puncturing or repetition pattern to the frame k can be obtained by the following steps:

- calculation of the mean puncturing distance q, where:

q: = $(\lfloor N_c/(|N_i-N_c|)\rfloor)$ mod K, where $\lfloor \ \rfloor$ means rounding down and $|\ |$ means an absolute value, and where:
$N_i$: = the number of bits after rate matching, and
$N_c$: = the number of bits before rate matching,

- calculation of Q, where: Q:= $(\lfloor N_c/|N_i-N_c|)\rfloor)$ div K;
- if q is even, then q is set to be q - lcd(q, K)/K, where lcd(q, K):= the largest common denominator of q and K;
- zeroing of a variable i;
- repetition of the following steps for as long as i $\leq$ K-1:

- S($R_K$ ($\lceil$ i*q$\rceil$ mod K)) = ($\lceil$ i*q$\rceil$ div K), where $\lceil \ \rceil$ means rounding up and $R_K$(k) reverses the interleaver;
- T(($R_K$ ($\lceil$ i*q$\rceil$ mod K)) = i where $\lceil \ \rceil$ means rounding up and $R_K$(k) reverses the interleaver;

- i becomes i + 1.

7. Method according to Claim 5,
in which the shift V(k) = S(k) in the application of the puncturing or repetition pattern to the frame k is obtained by the following steps:

- calculation of the mean puncturing distance q, where:

q: = $(\lfloor N_c/(|N_i-N_c|)\rfloor)$, where $\lfloor \ \rfloor$ means rounding down and $|\ |$ means an absolute value, and where:
$N_i$: = the number of bits after rate matching, and
$N_c$: = the number of bits before rate matching,

- if q is even, then q is set to be q - lcd(q, K)/K, where lcd(q, K):= the largest common denominator of q and K;
- zeroing of a variable i;
- repetition of the following steps for as long as i $\leq$ K-1:

- S($R_K$ ($\lceil$ i*q$\rceil$ mod K)) = ($\lceil$ i*q$\rceil$ div K), where $\lceil \ \rceil$ means rounding up and $R_K$(k) reverses the interleaver;
- $R_k^{(k)}$, where $R_K$(k) reverses the interleaver;

- i becomes i + 1.

8. Data rate matching apparatus for bits which are to be transmitted and are distributed by a first interleaver over a set of K frames,
having a rate converter which is designed such that a puncturing or repetition method is carried out after the interleaving process such that
in order to puncture or repeat the same number of bits in each frame, the distance between punctured or repeated bits is varied with respect to the sequence of the bits before the first interleaver,
with bits to be punctured or to be repeated being obtainable by means of a method which includes the following steps:

a) determination of the integer component q of the mean puncturing distance where

$$q: = (\lfloor N_c/(|N_i-N_c|)\rfloor),$$

where $\lfloor \ \rfloor$ means rounding down and $|\ |$ means an absolute value,
and where:

$N_i$: = the number of bits after rate matching, and
$N_c$: = the number of bits before rate matching;

b) selection of a bit to be punctured or to be repeated in a first frame;

c) selection of the next bit to be punctured or to be repeated in a next frame on the basis of the most recent bit to be punctured or to be repeated in the previous frame, in that, starting with this most recent bit to be punctured or to be repeated, the next bit is in each case selected at a distance q, with respect to the original sequence before the interleaver, provided that this does not lead to a frame being punctured or repeated twice, otherwise a bit at a distance q-1 or q+1, which is not the same as q, is selected for puncturing or repetition;

d) repetition of step c) until all of the frames have been punctured or repeated once.

9. Data rate matching apparatus according to Claim 8, having a rate converter which is designed such that bits in a first frame are punctured or repeated in accordance with a predetermined puncturing pattern or repetition pattern, and
that the puncturing pattern or repetition pattern is applied shifted to further frames for selection of further bits to be punctured or to be repeated, with the shift in the application of the puncturing pattern or repetition pattern to a further frame corresponding to the shift of the bit selected in step c) of Claim 1 in the further frame with respect to the bit selected in step b) in Claim 1.

10. Data rate matching apparatus for data which is to be transmitted and is distributed by a first interleaver over a set of K frames, in the form of bits,
having a rate converter which is designed such that puncturing or repetition method is carried out for data rate matching after the interleaving process, in such a way that
the same number of bits are punctured or repeated in each frame, in that
the puncturing or repetition pattern which is used within one frame is also applied shifted within further frames in the set of frames,
in that the set of K bits in the K frames which all correspond to this position (possibly shifted) is determined for each position in the puncturing or repetition pattern such that the distances between these K bits, with respect to the original sequence before the interleaver, is selected in accordance with a mean integer puncturing distance or repetition distance, except in the situation where the selection of this distance would lead to one frame being punctured or repeated twice, and in this situation a distance changed by one is selected.

**Revendications**

1. Procédé d'adaptation de débit de données, dans lequel
des bits à transmettre sont répartis par un premier entrelaceur sur un ensemble de K trames,
un procédé de poinçonnage ou de répétition est effectué, aux fins de l'adaptation du débit de données, après l'entrelacement, de manière telle que,
pour poinçonner ou répéter le même nombre de bits dans chaque trame la distance entre bits poinçonnés ou répétés est modifiée au regard de l'ordre des bits avant le premier entrelaceur,
des bits à poinçonner ou à répéter pouvant être obtenus par un procédé qui comporte les étapes suivantes:

a) détermination de la partie entière q de la distance moyenne de poinçonnage avec

$$q: = (\llcorner N_c / (| N_i - N_c| )\lrcorner),$$

$\llcorner$ $\lrcorner$ signifiant «arrondir par défaut» et $| |$ signifiant «valeur absolue» et étant entendu que

$N_i : =$ le nombre de bits après l'adaptation de débit,
$N_c : =$ le nombre de bits avant l'adaptation de débit;

b) sélection d'un bit à poinçonner ou à répéter dans une première trame;

c) sélection du bit suivant à poinçonner ou à répéter dans une trame suivante en partant du bit à poinçonner ou à répéter en dernier lieu dans la trame précédente du fait que, en commençant par ce bit à poinçonner ou à répéter en dernier lieu, on sélectionne respectivement le bit suivant avec une distance q, par rapport à l'ordre de départ avant l'entrelaceur, dans la mesure où ceci n'a pas pour conséquence qu'une trame fait double fois l'objet d'un poinçonnage ou d'une répétition, et qu'autrement un bit avec une distance q-1 ou q+1 modifiée par rapport à q est sélectionné aux fins du poinçonnage ou de la répétition;

d) répétition de l'étape c) jusqu'à ce que toutes les trames aient fait une fois l'objet d'un poinçonnage resp. d'une répétition.

**2.** Procédé selon la revendication 1, dans lequel
des bits d'une première trame sont poinçonnés ou répétés selon un schéma de poinçonnage ou de répétition donné et
aux fins de la sélection d'autres bits à poinçonner ou à répéter le schéma de poinçonnage ou de répétition est appliqué de manière décalée à d'autres trames, le décalage de l'application du schéma de poinçonnage ou de répétition à une autre trame correspondant au décalage du bit de l'autre trame sélectionné à l'étape c) de la revendication 1 par rapport au bit sélectionné à l'étape b) de la revendication 1.

**3.** Procédé d'adaptation de débit de données selon l'une des revendications 1 ou 2,
dans lequel la relation suivante est valable pour la distance:

$$q\text{-}1 \leq \text{distance} \leq q + \text{lcd}(q, K) +1,$$

avec
q: = ($\lfloor N_c / (| N_i - N_c|) \rfloor$) mod K, $\lfloor \ \rfloor$ signifiant «arrondir par défaut» et | | signifiant «valeur absolue» et étant entendu que $N_i$ : = le nombre de bits après l'adaptation de débit, $N_c$ : = le nombre de bits avant l'adaptation de débit;
lcd(q, K): = le plus grand commun dénominateur de q et de K.

**4.** Procédé selon la revendication 3,
dans lequel la relation suivante est également valable si le taux de poinçonnage ou le taux de répétition est égal à 1/K:

$$q\text{-}1 \leq \text{distance} \leq q + \text{lcd}(q, K) +1,$$

avec
q: = ($\lfloor N_c / (| N_i - N_c| ) \rfloor$) mod K, $\lfloor \ \rfloor$ signifiant «arrondir par défaut» et | | signifiant «valeur absolue» et étant entendu que $N_i$ : = le nombre de bits après l'adaptation de débit, $N_c$ : = le nombre de bits avant l'adaptation de débit;
lcd(q, K): = le plus grand commun dénominateur de q et de K.

**5.** Procédé d'adaptation de débit de données,
dans lequel des bits à transmettre sont répartis par un premier entrelaceur sur un ensemble de K trames,
un procédé de poinçonnage ou de répétition est effectué, aux fins de l'adaptation de débit de données, après l'entrelacement, de manière telle que le même nombre de bits est poinçonné resp. répété dans chaque trame,
le schéma de poinçonnage ou de répétition appliqué dans une trame est également appliqué, de manière décalée, dans d'autres trames de l'ensemble de trames,
pour chaque position du schéma de poinçonnage ou de répétition la quantité des K bits dans les K trames qui correspondent tous à cette position (décalée, le cas échéant) est déterminée de manière telle que les distances entre ces K bits, par rapport à l'ordre de départ avant l'entrelaceur, sont sélectionnées selon une distance de poinçonnage resp. de répétition moyenne entière excepté dans le cas où le choix de cette distance aurait pour conséquence qu'une trame ferait double fois l'objet d'un poinçonnage ou d'une répétition et, que, dans ce cas, on choisit une distance modifiée de un.

**6.** Procédé selon la revendication 5,
dans lequel le décalage V(k) = S(k) + T(k) * Q de l'application du schéma de poinçonnage ou de répétition à la trame k peut être obtenu par les étapes suivantes:

- calcul de la distance moyenne de poinçonnage q avec:

  q: = ($\lfloor N_c / (|N_i - N_c|) \rfloor$) mod K, $\lfloor \ \rfloor$ signifiant «arrondir par défaut» et | | signifiant «valeur absolue» et étant entendu que
  $N_i$ : = le nombre de bits après l'adaptation de débit,
  $N_c$ : = le nombre de bits avant l'adaptation de débit;

# EP 1 169 778 B1

- calcul de Q avec Q: = $(\lfloor N_c / (|N_i - N_c|)\rfloor)$ div K;
- si q est pair, alors q est mis à q - lcd(q, K) / K, avec lcd(q, K): = le plus grand commun dénominateur de q et de K;
- mise à zéro d'une variable i;
- répétition des étapes suivantes aussi longtemps que i ≤ K-1:

  - $S(R_k (\lceil i*q\rceil \bmod K)) = (\lceil i*q\rceil$ div K), $\lceil \ \rceil$ signifiant «arrondir par excès» et $R_k(k)$ inversant l'entrelaceur;
  - $T((R_k (\lceil i*q\rceil \bmod K)) = i$, $\lceil \ \rceil$ signifiant «arrondir par excès» et $R_k(k)$ inversant l'entrelaceur;
  - i est mis à i + 1.

**7.** Procédé selon la revendication 5,
dans lequel le décalage V(k) = S(k) de l'application du schéma de poinçonnage ou de répétition à la trame k peut être obtenu par les étapes suivantes:

- calcul de la distance moyenne de poinçonnage q avec:

  q: = $(\lfloor N_c / (| N_i - N_c| )\rfloor)$, $\lfloor \ \rfloor$ signifiant «arrondir par défaut» et | | signifiant «valeur absolue» et étant entendu que
  $N_i$ : = le nombre de bits après l'adaptation de débit,
  $N_c$ : = le nombre de bits avant l'adaptation de débit;

- si q est pair, alors q est mis à q - lcd(q, K) / K, avec lcd(q, K): = le plus grand commun dénominateur de q et de K;
- mise à zéro d'une variable i;
- répétition des étapes suivantes aussi longtemps que i ≤ K-1 :

  - $S(R_k (\lceil i*q\rceil \bmod K)) = (\lceil i*q\rceil$ div K), $\lceil \ \rceil$ signifiant «arrondir par excès» et $R_k(k)$ inversant l'entrelaceur;
  - $R_k(k)$, $R_k(k)$ inversant l'entrelaceur;
  - i est mis à i + 1.

**8.** Dispositif d'adaptation de débit de données pour des bits à transmettre, lesquels sont répartis par un premier entrelaceur sur un ensemble de K trames, comprenant un convertisseur de débit qui est configuré de manière telle qu'un procédé de poinçonnage ou de répétition est effectué, après l'entrelacement, de manière telle que, aux fins du poinçonnage ou de la répétition du même nombre de bits dans chaque trame, la distance entre bits poinçonnés ou répétés est modifiée au regard de l'ordre des bits avant le premier entrelaceur, des bits à poinçonner ou à répéter pouvant être obtenus par un procédé qui comporte les étapes suivantes:

  a) détermination de la partie entière q de la distance moyenne de poinçonnage avec

  $$q: = (\lfloor N_c/(|N_i - N_c|)\rfloor),$$

  $\lfloor \ \rfloor$ signifiant «arrondir par défaut» et | | signifiant «valeur absolue» et étant entendu que

  $N_i$ : = le nombre de bits après l'adaptation de débit,
  $N_c$ : = le nombre de bits avant l'adaptation de débit;

  b) sélection d'un bit à poinçonner ou à répéter dans une première trame;

  c) sélection du bit suivant à poinçonner ou à répéter dans une trame suivante en partant du bit à poinçonner ou à répéter en dernier lieu dans la trame précédente du fait que, en commençant par ce bit à poinçonner ou à répéter en dernier lieu, on sélectionne respectivement le bit suivant avec une distance q, par rapport à l'ordre de départ avant l'entrelaceur, dans la mesure où ceci n'a pas pour conséquence qu'une trame fait double fois l'objet d'un poinçonnage ou d'une répétition, et qu'autrement un bit avec une distance q-1 ou q+1 modifiée par rapport à q est sélectionné aux fins du poinçonnage ou de la répétition;

  d) répétition de l'étape c) jusqu'à ce que toutes les trames aient fait une fois l'objet d'un poinçonnage resp. d'une répétition.

**9.** Dispositif d'adaptation de débit de données selon la revendication 8, comprenant un convertisseur de débit qui est configuré de manière telle que des bits d'une première trame sont poinçonnés ou répétés selon un schéma de poinçonnage ou de répétition donné et

qu'aux fins de la sélection d'autres bits à poinçonner ou à répéter le schéma de poinçonnage ou de répétition est appliqué de manière décalée à d'autres trames, le décalage de l'application du schéma de poinçonnage ou de répétition à une autre trame correspondant au décalage du bit de l'autre trame sélectionné à l'étape c) de la revendication 1 par rapport au bit sélectionné à l'étape b) de la revendication 1.

10. Dispositif d'adaptation de débit de données pour des données sous forme de bits, à transmettre, lesquelles sont réparties par un premier entrelaceur sur un ensemble de K trames,

comprenant un convertisseur de débit qui est configuré de manière telle qu'un procédé de poinçonnage ou de répétition est effectué, aux fins de l'adaptation du débit de données, après l'entrelacement, de manière telle que le même nombre de bits est poinçonné resp. répété dans chaque trame,

le schéma de poinçonnage ou de répétition appliqué dans une trame est également appliqué, de manière décalée, dans d'autres trames de l'ensemble de trames,

pour chaque position du schéma de poinçonnage ou de répétition la quantité des K bits dans les K trames qui correspondent tous à cette position (décalée, le cas échéant) est déterminée de manière telle que les distances entre ces K bits, par rapport à l'ordre de départ avant l'entrelaceur, sont sélectionnées selon une distance de poinçonnage resp. de répétition moyenne entière excepté dans le cas où le choix de cette distance aurait pour conséquence qu'une trame ferait double fois l'objet d'un poinçonnage ou d'une répétition et, que, dans ce cas, on choisit une distance modifiée de un.

EP 1 169 778 B1

# FIG 1

**FIG 2**

Bit sequence  | 0 1 2 3 4 5 6 7 8 9 10 11 12 13 14 15 16 17 18 ...159 |

Row by row processing
8[4[2x2]x2]

| 0 | 1 | 2 | 3 | 4 | 5 | 6 | 7 |
|---|---|---|---|---|---|---|---|
| 8 | 9 | 10 | 11 | 12 | 13 | 14 | 15 |
| 16 | 17 | 18 | 19 | 20 | 21 | 22 | 23 |
| 24 | 25 | 26 | 27 | 28 | 29 | 30 | 31 |
| 32 | 33 | 34 | 35 | 36 | 37 | 38 | 39 |
| 40 | 41 | 42 | 43 | 44 | 45 | 46 | 47 |
| 48 | 49 | 50 | 51 | 52 | 53 | 54 | 55 |
| 56 | 57 | 58 | 59 | 60 | 61 | 62 | 63 |
| 64 | 65 | 66 | 67 | 68 | 69 | 70 | 71 |
| 72 | 73 | 74 | 75 | 76 | 77 | 78 | 79 |
| 80 | 81 | 82 | 83 | 84 | 85 | 86 | 87 |
| 88 | 89 | 90 | 91 | 92 | 93 | 94 | 95 |
| 96 | 97 | 98 | 99 | 100 | 101 | 102 | 103 |
| 104 | 105 | 106 | 107 | 108 | 109 | 110 | 111 |
| 112 | 113 | 114 | 115 | 116 | 117 | 118 | 119 |
| 120 | 121 | 122 | 123 | 124 | 125 | 126 | 127 |
| 128 | 129 | 130 | 131 | 132 | 133 | 134 | 135 |
| 136 | 137 | 138 | 139 | 140 | 141 | 142 | 143 |
| 144 | 145 | 146 | 147 | 148 | 149 | 150 | 151 |
| 152 | 153 | 154 | 155 | 156 | 157 | 158 | 159 |

$1^{st}$ interleaving

| 0 | 4 | 2 | 6 | 1 | 5 | 3 | 7 |
|---|---|---|---|---|---|---|---|
| 8 | 12 | 10 | 14 | 9 | 13 | 11 | 15 |
| 16 | 20 | 18 | 22 | 17 | 21 | 19 | 23 |
| 24 | 28 | 26 | 30 | 25 | 29 | 27 | 31 |
| **32** | **36** | **34** | **38** | **33** | **37** | **35** | **39** |
| 40 | 44 | 42 | 46 | 41 | 45 | 43 | 47 |
| 48 | 52 | 50 | 54 | 49 | 53 | 51 | 55 |
| 56 | 60 | 58 | 62 | 57 | 61 | 59 | 63 |
| 64 | 68 | 66 | 70 | 65 | 69 | 67 | 71 |
| **72** | **76** | **74** | **78** | **73** | **77** | **75** | **79** |
| 80 | 84 | 82 | 86 | 81 | 85 | 83 | 87 |
| 88 | 92 | 90 | 94 | 89 | 93 | 91 | 95 |
| 96 | 100 | 98 | 102 | 97 | 101 | 99 | 103 |
| 104 | 108 | 106 | 110 | 105 | 109 | 107 | 111 |
| **112** | **116** | **114** | **118** | **113** | **117** | **115** | **119** |
| 120 | 124 | 122 | 126 | 121 | 125 | 123 | 127 |
| 128 | 132 | 130 | 134 | 129 | 133 | 131 | 135 |
| 136 | 140 | 138 | 142 | 137 | 141 | 139 | 143 |
| 144 | 148 | 146 | 150 | 145 | 149 | 147 | 151 |
| **152** | **156** | **154** | **158** | **153** | **157** | **155** | **159** |

Radio frame #1
Radio frame #2  . . ..  Radio frame #8

**Bit sequence** | 0 1 2 3 4 5 6 7 8 9 10 11 12 13 14 15 16 17 18 ...159 |

## FIG 3

Row by row processing
8[4[2x2]x2]

| 0 | 1 | 2 | 3 | 4 | 5 | 6 | 7 |
|---|---|---|---|---|---|---|---|
| 8 | 9 | 10 | 11 | 12 | 13 | 14 | 15 |
| 16 | 17 | 18 | 19 | 20 | 21 | 22 | 23 |
| 24 | 25 | 26 | 27 | 28 | 29 | 30 | 31 |
| 32 | 33 | 34 | 35 | 36 | 37 | 38 | 39 |
| 40 | 41 | 42 | 43 | 44 | 45 | 46 | 47 |
| 48 | 49 | 50 | 51 | 52 | 53 | 54 | 55 |
| 56 | 57 | 58 | 59 | 60 | 61 | 62 | 63 |
| 64 | 65 | 66 | 67 | 68 | 69 | 70 | 71 |
| 72 | 73 | 74 | 75 | 76 | 77 | 78 | 79 |
| 80 | 81 | 82 | 83 | 84 | 85 | 86 | 87 |
| 88 | 89 | 90 | 91 | 92 | 93 | 94 | 95 |
| 96 | 97 | 98 | 99 | 100 | 101 | 102 | 103 |
| 104 | 105 | 106 | 107 | 108 | 109 | 110 | 111 |
| 112 | 113 | 114 | 115 | 116 | 117 | 118 | 119 |
| 120 | 121 | 122 | 123 | 124 | 125 | 126 | 127 |
| 128 | 129 | 130 | 131 | 132 | 133 | 134 | 135 |
| 136 | 137 | 138 | 139 | 140 | 141 | 142 | 143 |
| 144 | 145 | 146 | 147 | 148 | 149 | 150 | 151 |
| 152 | 153 | 154 | 155 | 156 | 157 | 158 | 159 |

| 0 | 4 | 2 | 6 | 1 | 5 | 3 | 7 |
|---|---|---|---|---|---|---|---|
| 8 | 12 | **10** | 14 | 9 | 13 | 11 | **15** |
| 16 | 20 | 18 | **22** | 17 | 21 | 19 | 23 |
| 24 | 28 | 26 | 30 | **25** | 29 | 27 | 31 |
| **32** | 36 | 34 | 38 | 33 | **37** | 35 | 39 |
| 40 | **44** | 42 | 46 | 41 | 45 | **43** | 47 |
| 48 | 52 | **50** | 54 | 49 | 53 | 51 | **55** |
| 56 | 60 | 58 | **62** | 57 | 61 | 59 | 63 |
| 64 | 68 | 66 | 70 | **65** | 69 | 67 | 71 |
| **72** | 76 | 74 | 78 | 73 | **77** | 75 | 79 |
| 80 | **84** | 82 | 86 | 81 | 85 | **83** | 87 |
| 88 | 92 | **90** | 94 | 89 | 93 | 91 | **55** |
| 96 | 100 | 98 | **102** | 97 | 101 | 99 | 103 |
| 104 | 108 | 106 | 110 | **105** | 109 | 107 | 111 |
| **112** | 116 | 114 | 118 | 113 | **117** | 115 | 119 |
| 120 | **124** | 122 | 126 | 121 | 125 | **123** | 127 |
| 128 | 132 | **130** | 134 | 129 | 133 | 131 | **135** |
| 136 | 140 | 138 | **142** | 137 | 141 | 139 | 143 |
| 144 | 148 | 146 | 150 | **145** | 149 | 147 | 151 |
| **152** | 156 | 154 | 158 | 153 | **157** | 155 | 159 |

Radio frame #1

Radio frame #2

...

Radio frame #8

Bit sequence: | 0 1 2 3 4 5 6 7 8 9 10 11 12 13 14 15 16 17 18 ...159 |

## FIG 4

Row by row processing
8[4[2x2]x2]

| 0 | 1 | 2 | 3 | 4 | 5 | 6 | 7 |
|---|---|---|---|---|---|---|---|
| 8 | 9 | 10 | 11 | 12 | 13 | 14 | 15 |
| 16 | 17 | 18 | 19 | 20 | 21 | 22 | 23 |
| 24 | 25 | 26 | 27 | 28 | 29 | 30 | 31 |
| 32 | 33 | 34 | 35 | 36 | 37 | 38 | 39 |
| 40 | 41 | 42 | 43 | 44 | 45 | 46 | 47 |
| 48 | 49 | 50 | 51 | 52 | 53 | 54 | 55 |
| 56 | 57 | 58 | 59 | 60 | 61 | 62 | 63 |
| 64 | 65 | 66 | 67 | 68 | 69 | 70 | 71 |
| 72 | 73 | 74 | 75 | 76 | 77 | 78 | 79 |
| 80 | 81 | 82 | 83 | 84 | 85 | 86 | 87 |
| 88 | 89 | 90 | 91 | 92 | 93 | 94 | 95 |
| 96 | 97 | 98 | 99 | 100 | 101 | 102 | 103 |
| 104 | 105 | 106 | 107 | 108 | 109 | 110 | 111 |
| 112 | 113 | 114 | 115 | 116 | 117 | 118 | 119 |
| 120 | 121 | 122 | 123 | 124 | 125 | 126 | 127 |
| 128 | 129 | 130 | 131 | 132 | 133 | 134 | 135 |
| 136 | 137 | 138 | 139 | 140 | 141 | 142 | 143 |
| 144 | 145 | 146 | 147 | 148 | 149 | 150 | 151 |
| 152 | 153 | 154 | 155 | 156 | 157 | 158 | 159 |

| 0 | 4 | 2 | 6 | 1 | 5 | 3 | 7 |
|---|---|---|---|---|---|---|---|
| 8 | **12** | 10 | 14 | 9 | 13 | **11** | 15 |
| 16 | 20 | 18 | 22 | 17 | 21 | 19 | 23 |
| 24 | 28 | **26** | 30 | 25 | 29 | 27 | **31** |
| 32 | 36 | 34 | 38 | 33 | 37 | 35 | 39 |
| 40 | 44 | 42 | **46** | 41 | 45 | 43 | 47 |
| 48 | 52 | 50 | 54 | 49 | 53 | 51 | 55 |
| 56 | 60 | 58 | 62 | **57** | 61 | 59 | 63 |
| 64 | 68 | 66 | 70 | 65 | 69 | 67 | 71 |
| **72** | 76 | 74 | 78 | 73 | **77** | 75 | 79 |
| 80 | 84 | 82 | 86 | 81 | 85 | 83 | 87 |
| 88 | **92** | 90 | 94 | 89 | 93 | **91** | 55 |
| 96 | 100 | 98 | 102 | 97 | 101 | 99 | 103 |
| 104 | 108 | **106** | 110 | 105 | 109 | 107 | **111** |
| 112 | 116 | 114 | 118 | 113 | 117 | 115 | 119 |
| 120 | 124 | 122 | **126** | 121 | 125 | 123 | 127 |
| 128 | 132 | 130 | 134 | 129 | 133 | 131 | 135 |
| 136 | 140 | 138 | 142 | **137** | 141 | 139 | 143 |
| 144 | 148 | 146 | 150 | 145 | 149 | 147 | 151 |
| **152** | 156 | 154 | 158 | 153 | **157** | 155 | 159 |

Radio frame #1

Radio frame #2

...

Radio frame #8

# FIG 5

TrCH A

| Transport block |

| Transport block |

| Transport block |

| Transport block |

Transport block (right side, 40 ms)

Transport block

Transport block

Transport block

10 ms    20 ms    30 ms    40 ms

←————————————— Transmission time interval —————————————→

TrCH B

| Transport block |    | Transport block |    | Transport block |    | Transport block |

10 ms    20 ms    30 ms    40 ms

←——→ Transmission time interval

EP 1 169 778 B1

Input bit sequence | 0 1 2 3 4 5 6 7 8 9 10 11 12 13 14 15 16 17 18 ...159 |

1st stage block Interleaving

FIG 6

Puncturing with simple shifting rule

| 0 | 1 | 2 | 3 | 4 | 5 | 6 | 7 |
|---|---|---|---|---|---|---|---|
| 8 | 9 | 10 | 11 | 12 | 13 | 14 | 15 |
| 16 | 17 | 18 | 19 | 20 | 21 | 22 | 23 |
| 24 | 25 | 26 | 27 | 28 | 29 | 30 | 31 |
| 32 | 33 | 34 | 35 | 36 | 37 | 38 | 39 |
| 40 | 41 | 42 | 43 | 44 | 45 | 46 | 47 |
| 48 | 49 | 50 | 51 | 52 | 53 | 54 | 55 |
| 56 | 57 | 58 | 59 | 60 | 61 | 62 | 63 |
| 64 | 65 | 66 | 67 | 68 | 69 | 70 | 71 |
| 72 | 73 | 74 | 75 | 76 | 77 | 78 | 79 |
| 80 | 81 | 82 | 83 | 84 | 85 | 86 | 87 |
| 88 | 89 | 90 | 91 | 92 | 93 | 94 | 95 |
| 96 | 97 | 98 | 99 | 100 | 101 | 102 | 103 |
| 104 | 105 | 106 | 107 | 108 | 109 | 110 | 111 |
| 112 | 113 | 114 | 115 | 116 | 117 | 118 | 119 |
| 120 | 121 | 122 | 123 | 124 | 125 | 126 | 127 |
| 128 | 129 | 130 | 131 | 132 | 133 | 134 | 135 |
| 136 | 137 | 138 | 139 | 140 | 141 | 142 | 143 |
| 144 | 145 | 146 | 147 | 148 | 149 | 150 | 151 |
| 152 | 153 | 154 | 155 | 156 | 157 | 158 | 159 |

Column randomizing

| 0 | 4 | 2 | 6 | 1 | 5 | 3 | 7 |
|---|---|---|---|---|---|---|---|
| 8 | 12 | 10 | 14 | 9 | 13 | 11 | 15 |
| 16 | 20 | 18 | 22 | 17 | 21 | 19 | 23 |
| 24 | 28 | 26 | 30 | 25 | 29 | 27 | 31 |
| 32 | 36 | 34 | 38 | 33 | 37 | 35 | 39 |
| 40 | 44 | 42 | 46 | 41 | 45 | 43 | 47 |
| 48 | 52 | 50 | 54 | 49 | 53 | 51 | 55 |
| 56 | 60 | 58 | 62 | 57 | 61 | 59 | 63 |
| 64 | 68 | 66 | 70 | 65 | 69 | 67 | 71 |
| 72 | 76 | 74 | 78 | 73 | 77 | 75 | 79 |
| 80 | 84 | 82 | 86 | 81 | 85 | 83 | 87 |
| 88 | 92 | 90 | 94 | 89 | 93 | 91 | 55 |
| 96 | 100 | 98 | 102 | 97 | 101 | 99 | 103 |
| 104 | 108 | 106 | 110 | 105 | 109 | 107 | 111 |
| 112 | 116 | 114 | 118 | 113 | 117 | 115 | 119 |
| 120 | 124 | 122 | 126 | 121 | 125 | 123 | 127 |
| 128 | 132 | 130 | 134 | 129 | 133 | 131 | 135 |
| 136 | 140 | 138 | 142 | 137 | 141 | 139 | 143 |
| 144 | 148 | 146 | 150 | 145 | 149 | 147 | 151 |
| 152 | 156 | 154 | 158 | 153 | 157 | 155 | 159 |

Frame #1 — Frame #2 ... Frame #8

# FIG 7

# FIG 8

EP 1 169 778 B1

```
   ┌─────┐   ┌─────┐              6'              6"
   │  8  │   │ 14  │              │               │
   └──┬──┘   └──┬──┘              Y               Y
      │         │                 │               ↑
┌─────┐  ┌─────┐  ┌─────┐  ┌─────┐       ┌─────┐  ┌─────┐  ┌─────┐  ┌─────┐
│ 10  │→ │ 12  │→ │ 16  │→ │ 18  │       │ 22  │→ │ 24  │→ │ 26  │→ │ 30  │
└─────┘  └─────┘  └─────┘  └─────┘       └─────┘  └──┬──┘  └──┬──┘  └─────┘
                                                     └────────┘
                                                         │
                                                        28
```

**FIG 9**

| 0 | 1 | 2 | 3 | **4** | 5 | 6 | 7 |
|---|---|---|---|---|---|---|---|
| 8 | 9 | 10 | 11 | 12 | **13** | 14 | 15 |
| 16 | 17 | 18 | 19 | 20 | 21 | **22** | 23 |
| 24 | 25 | 26 | 27 | 28 | 29 | 30 | **31** |
| **32** | 33 | 34 | 35 | 36 | 37 | 38 | 39 |
| 40 | **41** | 42 | 43 | 44 | 45 | 46 | 47 |
| 48 | 49 | **50** | 51 | 52 | 53 | 54 | 55 |
| 56 | 57 | 58 | **59** | 60 | 61 | 62 | 63 |
| 64 | 65 | 66 | 67 | **68** | 69 | 70 | 71 |
| 72 | 73 | 74 | 75 | 76 | **77** | 78 | 79 |
| 80 | 81 | 82 | 83 | 84 | 85 | **86** | 87 |
| 88 | 89 | 90 | 91 | 92 | 93 | 94 | **95** |
| **96** | 97 | 98 | 99 | 100 | 101 | 102 | 103 |
| 104 | **105** | 106 | 107 | 108 | 109 | 110 | 111 |
| 112 | 113 | **114** | 115 | 116 | 117 | 118 | 119 |
| 120 | 121 | 122 | **123** | 124 | 125 | 126 | 127 |

P6  P5

**FIG 10**

| **0** | 1 | 2 | 3 | 4 | 5 | **6** | 7 |
|---|---|---|---|---|---|---|---|
| 8 | 9 | 10 | 11 | **12** | 13 | 14 | 15 |
| 16 | 17 | **18** | 19 | 20 | 21 | 22 | **23** |
| 24 | 25 | 26 | 27 | 28 | **29** | 30 | 31 |
| 32 | 33 | 34 | **35** | 36 | 37 | 38 | 39 |
| 40 | **41** | 42 | 43 | 44 | 45 | 46 | 47 |
| **48** | 49 | 50 | 51 | 52 | 53 | **54** | 55 |
| 56 | 57 | 58 | 59 | **60** | 61 | 62 | 63 |
| 64 | 65 | **66** | 67 | 68 | 69 | 70 | **71** |
| 72 | 73 | 74 | 75 | 76 | **77** | 78 | 79 |
| 80 | 81 | 82 | **83** | 84 | 85 | 86 | 87 |

26

# FIG 11

| S;T | K | 1 | 2 | | 4 | | | | 8 | | | | | | | |
|---|---|---|---|---|---|---|---|---|---|---|---|---|---|---|---|---|
| | k | 0 | 0 | 1 | 0 | 1 | 2 | 3 | 0 | 1 | 2 | 3 | 4 | 5 | 6 | 7 |
| Q | 1 | 0;0 | 0;0 | 0;1 | 0;0 | 0;2 | 0;1 | 0;3 | 0;0 | 0;4 | 0;2 | 0;6 | 0;1 | 0;5 | 0;3 | 0;7 |
| | 2 | | 0;0 | 1;1 | 0;0 | 0;1 | 1;3 | 0;2 | 0;0 | 0;2 | 0;1 | 0;3 | 1;5 | 1;7 | 1;6 | 0;4 |
| | 3 | | | | 0;0 | 1;2 | 2;3 | 0;1 | 0;0 | 1;4 | 2;6 | 0;2 | 1;3 | 2;7 | 0;1 | 1;5 |
| | 4 | | | | 0;0 | 1;2 | 2;3 | 0;1 | 0;0 | 0;1 | 2;5 | 1;4 | 3;7 | 2;6 | 1;3 | 0;2 |
| | 5 | | | | | | | | 0;0 | 3;4 | 2;2 | 4;6 | 4;5 | 1;1 | 5;7 | 2;3 |
| | 6 | | | | | | | | 0;0 | 1;2 | 2;3 | 0;1 | 5;7 | 3;5 | 4;6 | 2;4 |
| | 7 | | | | | | | | 0;0 | 3;4 | 5;6 | 1;2 | 6;7 | 2;3 | 4;5 | 0;1 |
| | 8 | | | | | | | | 0;0 | 3;4 | 5;6 | 1;2 | 6;7 | 2;3 | 4;5 | 0;1 |

EP 1 169 778 B1

EP 1 169 778 B1

**FIG 12**

| 0 | 1 | **2** | 3 | 4 | 5 | 6 | **7** |
|---|---|---|---|---|---|---|---|
| 8 | 9 | 10 | 11 | **12** | 13 | 14 | 15 |
| 16 | **17** | 18 | 19 | 20 | 21 | **22** | 23 |
| 24 | 25 | 26 | **27** | 28 | 29 | 30 | 31 |
| **32** | 33 | 34 | 35 | 36 | **37** | 38 | 39 |
| 40 | 41 | **42** | 43 | 44 | 45 | 46 | **47** |
| 48 | 49 | 50 | 51 | **52** | 53 | 54 | 55 |
| 56 | **57** | 58 | 59 | 60 | 61 | **62** | 63 |
| 64 | 65 | 66 | **67** | 68 | 69 | 70 | 71 |
| **72** | 73 | 74 | 75 | 76 | **77** | 78 | 79 |
| 80 | 81 | **82** | 83 | 84 | 85 | 86 | **87** |
| 88 | 89 | 90 | 91 | **92** | 93 | 94 | 95 |
| 96 | **97** | 98 | 99 | 100 | 101 | **102** | 103 |
| 104 | 105 | 106 | **107** | 108 | 109 | 110 | 111 |
| **112** | 113 | 114 | 115 | 116 | **117** | 118 | 119 |
| 120 | 121 | **122** | 123 | 124 | 125 | 126 | **127** |
| 128 | 129 | 130 | 131 | **132** | 133 | 134 | 135 |
| 136 | **137** | 138 | 139 | 140 | 141 | **142** | 143 |
| 144 | 145 | 146 | **147** | 148 | 149 | 150 | 151 |
| **152** | 153 | 154 | 155 | 156 | **157** | 158 | 159 |

**FIG 13**

| 0 | 1 | 2 | **3** | 4 | 5 | 6 | 7 |
|---|---|---|---|---|---|---|---|
| 8 | 9 | **10** | 11 | 12 | 13 | 14 | 15 |
| 16 | **17** | 18 | 19 | 20 | 21 | 22 | 23 |
| 24 | 25 | 26 | 27 | 28 | 29 | 30 | 31 |
| **32** | 33 | 34 | 35 | 36 | 37 | 38 | **39** |
| 40 | 41 | 42 | 43 | 44 | 45 | **46** | 47 |
| 48 | 49 | 50 | 51 | 52 | **53** | 54 | 55 |
| 56 | 57 | 58 | 59 | **60** | 61 | 62 | 63 |
| 64 | 65 | 66 | **67** | 68 | 69 | 70 | 71 |
| 72 | 73 | **74** | 75 | 76 | 77 | 78 | 79 |
| 80 | **81** | 82 | 83 | 84 | 85 | 86 | 87 |
| 88 | 89 | 90 | 91 | 92 | 93 | 94 | 95 |
| **96** | 97 | 98 | 99 | 100 | 101 | 102 | **103** |
| 104 | 105 | 106 | 107 | 108 | 109 | **110** | 111 |
| 112 | 113 | 114 | 115 | 116 | **117** | 118 | 119 |
| 120 | 121 | 122 | 123 | **124** | 125 | 126 | 127 |

| 0 | 1 | 2 | 3 | 4 | 5 | 6 | 7 |
|---|---|---|---|---|---|---|---|
| 8 | 9 | 10 | 11 | 12 | 13 | 14 | 15 |
| 16 | 17 | 18 | 19 | 20 | 21 | 22 | 23 |
| 24 | 25 | 26 | 27 | 28 | 29 | 30 | 31 |
| 32 | 33 | 34 | 35 | 36 | 37 | 38 | 39 |
| 40 | 41 | 42 | 43 | 44 | 45 | 46 | 47 |
| 48 | 49 | 50 | 51 | 52 | 53 | 54 | 55 |
| 56 | 57 | 58 | 59 | 60 | 61 | 62 | 63 |
| 64 | 65 | 66 | 67 | 68 | 69 | 70 | 71 |
| 72 | 73 | 74 | 75 | 76 | 77 | 78 | 79 |
| 80 | 81 | 82 | 83 | 84 | 85 | 86 | 87 |
| 88 | 89 | 90 | 91 | 92 | 93 | 94 | 95 |
| 96 | 97 | 98 | 99 | 100 | 101 | 102 | 103 |
| 104 | 105 | 106 | 107 | 108 | 109 | 110 | 111 |
| 112 | 113 | 114 | 115 | 116 | 117 | 118 | 119 |
| 120 | 121 | 122 | 123 | 124 | 125 | | |

FIG 14

Best solution to puncture n bits

Puncture n+1 bits as above plus one extra bit

Puncture n+1 bits with optimised algorithm

FIG 15